# EUROPEAN PATENT APPLICATION

(11) **EP 4 719 015 A1**
(43) Date of publication of application: **01.04.2026**
(21) Application number: 25205476.2
(22) Date of filing: 29.09.2025
(51) Int. Cl.: H10K 59/122, H10K 59/131, H10K 59/80, H10K 59/35

(54) **ELECTRONIC DEVICE**

(30) Priority: 30.09.2024 KR 20240132525; 01.11.2024 KR 20240153481
(71) Applicant: Samsung Display Co., Ltd., Yongin-si, Gyeonggi-do 17113 (KR)
(72) Inventor: KIM, Sikwang, 17113 Yongin-si (KR); KANG, Ki Nyeng, 17113 Yongin-si (KR); KWON, Dohyun, 17113 Yongin-si (KR); NAM, Yunyong, 17113 Yongin-si (KR); MOON, Junhwan, 17113 Yongin-si (KR); PARK, Jonghee, 17113 Yongin-si (KR); PARK, Chanju, 17113 Yongin-si (KR); BAEK, Jongjun, 17113 Yongin-si (KR); LEE, Kyoungwon, 17113 Yongin-si (KR); LEE, Sungeun, 17113 Yongin-si (KR); LEE, Jaehun, 17113 Yongin-si (KR)
(74) Representative: Walaski, Jan Filip

(57) **Abstract**

An electronic device includes a substrate including a display area including emission areas and a non-emission area between the emission areas and including a normal area and support areas, an interlayer insulating layer on the substrate, a pixel-defining layer on the interlayer insulating layer and defining opening portions overlapping the emission areas, light emitting elements, each including a first electrode on the interlayer insulating layer and overlapping a respective one of the opening portions, a common layer on the first electrode, and a second electrode on the common layer, and a partition wall on the pixel-defining layer and overlapping the non-emission area. A distance from the interlayer insulating layer to the partition wall in each of the support areas is greater than a distance from the interlayer insulating layer to the partition wall in the normal area.

## Description

### CROSS-REFERENCE TO RELATED APPLICATIONS

The present application claims priority to Korean Patent Application No. 10-2024-0132525, filed on September 30, 2024, in the Korean Intellectual Property Office, and Korean Patent Application No. 10-2024-0153481, filed on November 01, 2024, in the Korean Intellectual Property Office.

### BACKGROUND

The present disclosure relates to an electronic device, and, for example, to an electronic device with improved display quality.

In general, electronic equipment such as smartphones, digital cameras, notebook computers, navigation devices, and smart televisions, which provide images for users, include electronic devices for displaying the images. An electronic device generates an image and provides a user with the generated image through a display screen.

Electronic devices may include a plurality of pixels for generating images, and a plurality of lines connected to the pixels. The pixels are driven by receiving driving signals through the lines.

In medium and large-sized electronic devices, such as tablet computers or smart televisions having larger surface areas, a difference may occur between driving voltages transmitted to different pixels, and a design to compensate for this difference is desired or required.

The above information disclosed in this Background section is intended to enhance understanding of the background of the disclosure and may contain information that does not constitute prior art.

### SUMMARY

Aspects of one or more embodiments of the present disclosure are directed to an electronic device capable of providing a substantially uniform driving voltage to pixels.

Aspects of one or more embodiments of the present disclosure are directed to an electronic device in which power lines are connected to electrodes for the light-emitting elements in the display area, reducing the size of the non-display area.

Aspects of one or more embodiments of the present disclosure are directed to an electronic device in which the structure of the connection between the power lines and the electrodes for the light-emitting elements is protected from damage by being spaced from a mask used during manufacturing.

Additional aspects will be set forth in part in the description which follows and, in part, will be apparent from the description, or may be learned by practice of the presented embodiments of the disclosure.

One or more embodiments of the present disclosure provides an electronic device including a substrate including a display area, the display area including emission areas and a non-emission area arranged between the emission areas and including a normal area and support areas, an interlayer insulating layer arranged on the substrate, a pixel-defining layer arranged on the interlayer insulating layer and defining opening portions overlapping the emission areas, light-emitting elements, each including a first electrode arranged on the interlayer insulating layer and overlapping a respective one of the opening portions, a common layer arranged on the first electrode, and a second electrode arranged on the common layer, and a partition wall arranged on the pixel-defining layer and overlapping the non-emission area. A distance from the interlayer insulating layer to the partition wall arranged in each of the support areas is greater than a distance from the interlayer insulating layer to the partition wall arranged in the normal area.

In one or more embodiments, the electronic device may further include stepped organic patterns arranged between the partition wall and the pixel-defining layer, the stepped organic patterns overlapping the support areas.

In one or more embodiments, the pixel-defining layer may include an organic material having a light blocking property and the pixel-defining layer may have a certain color.

In one or more embodiments, the stepped organic patterns may each include a transparent organic material.

In one or more embodiments, the stepped organic patterns may include the same material as the pixel-defining layer.

In one or more embodiments, a surface area of the stepped organic patterns within the display area may be in a range of 1% to 10% of a surface area of the display area.

In one or more embodiments, the electronic device may further include a stepped organic film including a first pattern covering the pixel-defining layer, and second patterns connected to the first pattern and arranged between the partition wall and the pixel-defining layer, each of the second patterns overlapping a respective one of the support areas, and a thickness of the second patterns may be greater than a thickness of the first pattern.

In one or more embodiments, the partition wall may include a first insulating pattern, a second insulating pattern arranged on the first insulating pattern, a first partition wall pattern arranged on the second insulating pattern, a second partition wall pattern arranged on the first partition wall pattern, and a spacer arranged on the second partition wall pattern.

In one or more embodiments, the first insulating pattern may include at least one of indium zinc oxide, indium gallium zinc oxide, or indium tin oxide, and the second insulating pattern may include at least one of silicon oxide, silicon oxynitride, or silicon nitride.

In one or more embodiments, the first partition wall pattern may include aluminum, and the second partition wall pattern may include titanium.

In one or more embodiments, a thickness of the first partition wall pattern may be greater than a thickness of the second partition wall pattern, a width of the second partition wall pattern may be greater than a width of the first partition wall pattern, and a portion of a bottom surface of the second partition wall pattern may protrude from the first partition wall pattern and may be exposed from the first partition wall pattern.

In one or more embodiments, the second electrode may be a single pattern provided in common to the light-emitting elements, and the second electrode may extend from the emission areas to the non-emission area and cover a side surface of the first partition wall pattern, the portion of the bottom surface of the second partition wall pattern, and the spacer.

In one or more embodiments, the electronic device may further include power lines configured to provide power to the light-emitting elements, overlapping the display area, and arranged between the interlayer insulating layer and the substrate.

In one or more embodiments, the non-emission area may further include contact areas arranged within the normal area and spaced and/or apart (*e*.*g*., spaced apart or separated) from the support areas, and in the contact areas, the interlayer and the pixel-defining layer may define contact holes passing through the interlayer insulating layer and the pixel-defining layer, respectively, and the contact holes may expose the power lines. The first partition wall pattern may be in contact with the power lines exposed by the contact holes.

In one or more embodiments, in the contact areas, the first insulating pattern may be arranged on the pixel-defining layer, and the second insulating pattern may cover a side surface of the pixel-defining layer and a side surface of the interlayer insulating layer which define the contact holes.

In one or more embodiments, the spacer may include a transparent organic material.

In one or more embodiments, the electronic device may further include an encapsulation layer w arranged on the pixel-defining layer and covering the light-emitting elements, and the encapsulation layer may include inorganic layers and an organic layer arranged between the inorganic layers.

In one or more embodiments, the substrate may include a non-display area around (*e*.*g*., surrounding) at least a portion of the display area, and the electronic device may further include a dam pattern arranged on the substrate and defining a boundary of the organic layer in the non-display area.

In one or more embodiments, the dam pattern may include a plurality of layers, and the layers may include the same material as at least one of the interlayer insulating layer, the pixel-defining layer, the stepped organic pattern, or the spacer.

In one or more embodiments, the emission areas may include a first emission area to emit light of a first color, a second emission area to emit light of a second color different from the first color and is spaced and/or apart (*e*.*g*., spaced apart or separated) from the first emission area in a first direction, and a (3-1)-th emission area and a (3-2)-th emission area, each of which is to emit light of a third color different from the first and second colors and which are spaced and/or apart (*e*.*g*., spaced apart or separated) from each other in a second direction crossing the first direction.

In one or more embodiments, the (3-1)-th emission area may be spaced and/or apart (*e*.*g*., spaced apart or separated) from the first emission area in a first diagonal direction crossing the first and second directions, and the (3-2)-th emission area may be spaced and/or apart (*e*.*g*., spaced apart or separated) from the second emission area in a second diagonal direction crossing the first diagonal direction.

### BRIEF DESCRIPTION OF THE DRAWINGS

FIG. 1A is a perspective view of an electronic device.
FIG. 1B is a block diagram of an electronic device.
FIG. 2 is a cross-sectional view of an electronic device.
FIG. 3 is a cross-sectional view of a display panel.
FIG. 4A is a block diagram of a display module.
FIG. 4B is an equivalent circuit diagram of one of pixels illustrated in FIG. 4A.
FIG. 5 is a plan view of a portion of a display area of the display panel.
FIG. 6 is a cross-sectional view taken along the line I-I' in FIG. 5.
FIG. 7 is an enlarged cross-sectional view of a partition wall illustrated in FIG. 6.
FIG. 8 is a cross-sectional view taken along the line II-II' in FIG. 5.
FIG. 9 is a cross-sectional view taken along the line III-III' in FIG. 5.
FIG. 10A is a cross-sectional view taken along the line II-II' in FIG. 5 of a partition wall arranged in a support area.
FIG. 10B is a cross-sectional view of a partition wall arranged in a normal area and a contact area.
FIG. 11 is a cross-sectional view taken along the line II-II' in FIG. 5 of a partition wall arranged in a support area.

### DETAILED DESCRIPTION

The present disclosure may be modified in many alternate forms, and thus specific embodiments will be illustrated in the drawings and described in more detail. It should be understood, however, that this is not intended to limit the present disclosure to the particular forms disclosed, but rather, is intended to cover all modifications, equivalents, and alternatives falling within the spirit and scope of the present disclosure.

Hereinafter, example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

It will be understood that when an element, such as an area, layer, film, region or portion, is referred to as being "on," "connected to," or "coupled to" another element, it can be directly on, connected to, or coupled to the other element, or one or more intervening elements may be present. In contrast, when an element or layer is referred to as being "directly on," "directly connected to", "directly coupled to", or "immediately adjacent to" another element or layer, there are no intervening elements or layers present. In addition, it will also be understood that when an element is referred to as being "between" two elements, it can be the only element between the two elements, or one or more intervening elements may also be present.

Unless otherwise noted, like reference numerals denote like elements throughout the attached drawings and the written description, and thus, duplicative descriptions thereof may not be provided. In the drawings, the relative sizes (*e*.*g*., including lengths, widths and thicknesses) of elements, layers, and regions may be exaggerated for clarity.

The term "and/or" includes any and all combinations of one or more of the associated listed elements.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

As used herein, the singular forms "a," "an" and "the" are intended to include the plural forms as well, unless the context clearly indicates otherwise.

Spatially relative terms, such as "on," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the drawings. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (*e*.*g*., rotated 90 degrees or at other orientations) and the spatially relative descriptors used herein should be interpreted accordingly.

It will be further understood that the terms "comprises," "comprising," "includes," "including," "have," and "having," when used in this specification, specify the presence of the stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

Unless otherwise apparent from the disclosure, expressions such as "at least one of," "a plurality of," "one of," and other prepositional phrases, when preceding a list of elements, should be understood as including the disjunctive if written as a conjunctive list and vice versa. For example, the expressions "at least one of a, b, or c," "at least one of a, b, and/or c," "one selected from the group consisting of a, b, and c," "at least one selected from among a, b, and c," "at least one from among a, b, and c," "one from among a, b, and c", "at least one of a to c" indicates only a, only b, only c, both a and b, both a and c, both b and c, all of a, b, and c, or variations thereof.

As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, embodiments will be described with reference to the accompanying drawings.

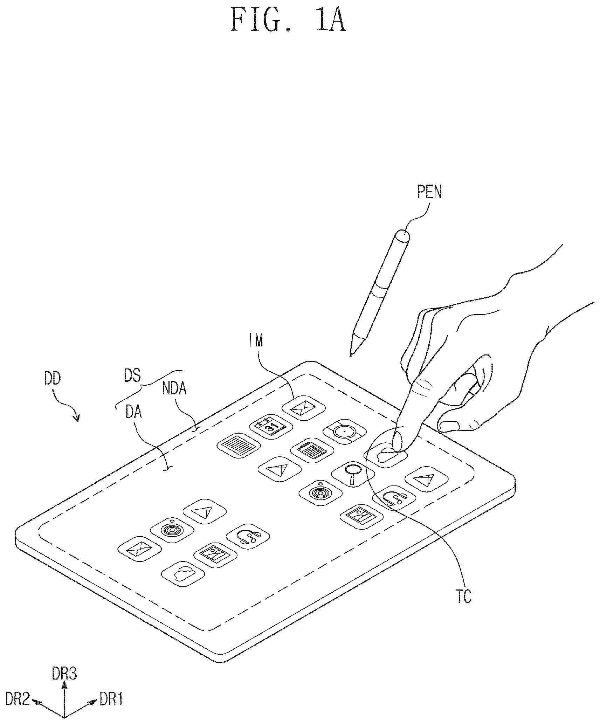

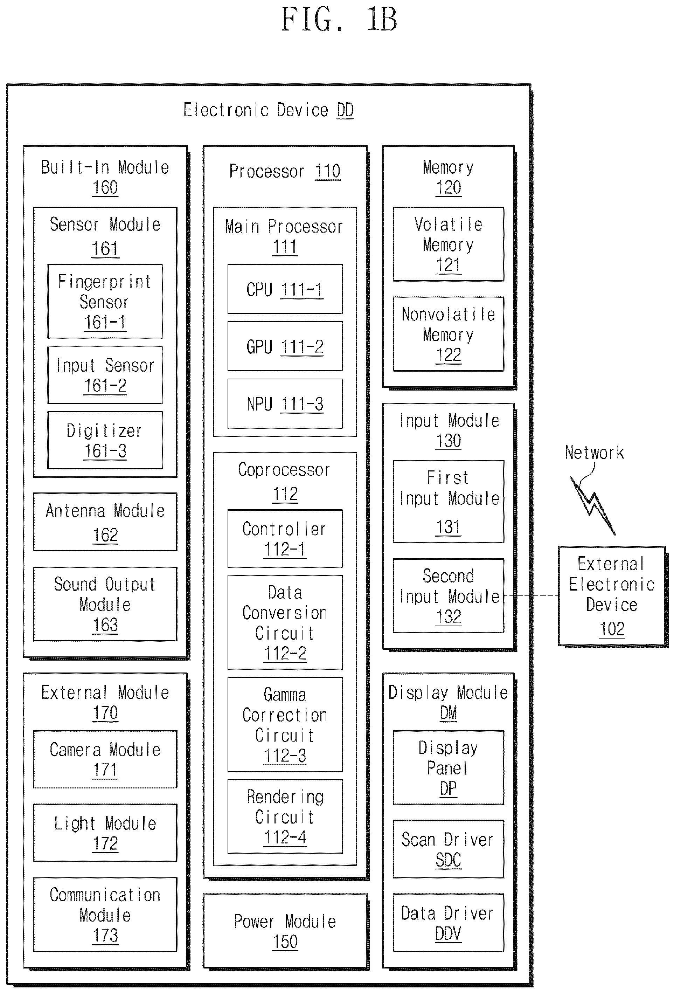

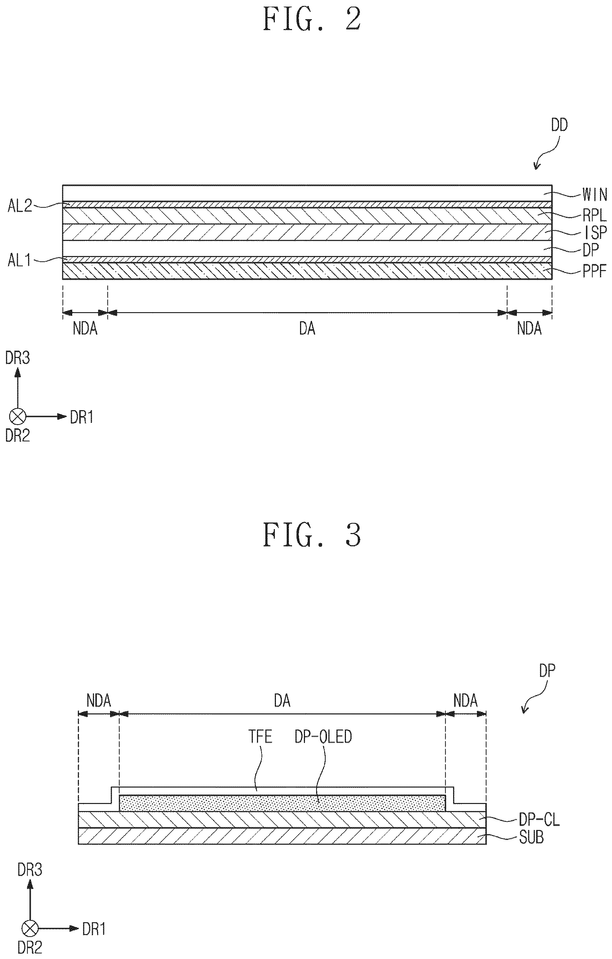

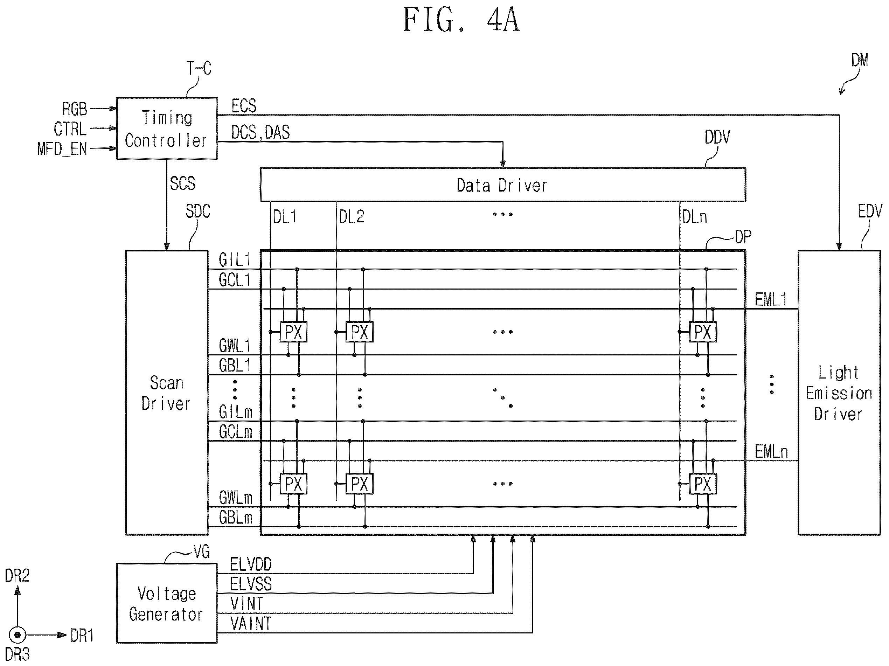

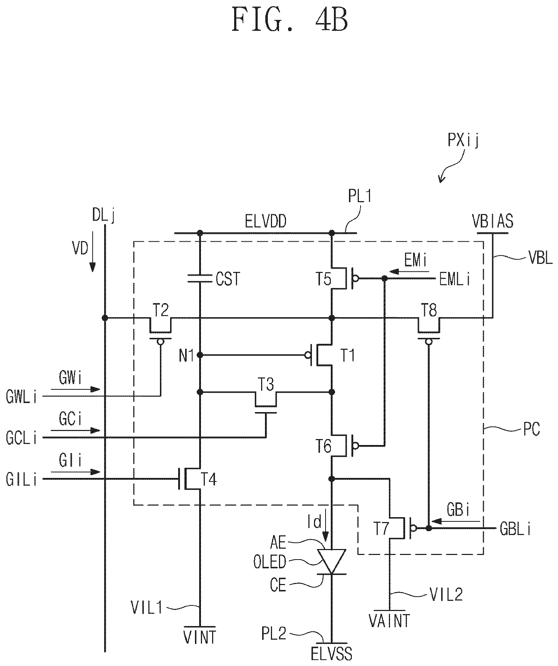

FIG. 1A is a perspective view of an electronic device. FIG. 1B is a block diagram of an electronic device. FIG. 2 is a cross-sectional view of an electronic device. FIG. 3 is a cross-sectional view of a display panel. FIG. 4A is a block diagram of a display module. FIG. 4B is an equivalent circuit diagram of one of pixels illustrated in FIG. 4A.

Referring to FIG. 1A, an electronic device DD may have long sides extending to be parallel to a first direction DR1 and short sides extending to be parallel to a second direction DR2 crossing the first direction DR1. Corners of the electronic device DD, which connect the long sides to the short sides, may have curved shapes. The corners of the electronic device DD, which may have curved shapes (*e*.*g*., may have the shape of a curve), may be referred to as round or rounded corners. This shape of the electronic device DD may be defined as a round cornered rectangle. However, this is just one example of the shape of the electronic device DD, and the shape of the electronic device DD is not limited to the round cornered rectangle.

Hereinafter, a direction substantially normal (*e*.*g*., perpendicular) to a plane defined by the first direction DR1 and the second direction DR2 is defined as a third direction DR3. In addition, in the specification, the meaning of when viewed on a plane is defined as being in a state when viewed in the third direction DR3 (*e*.*g*., in a plan view).

A front surface of the electronic device DD may be defined as a display surface DS, and may extend along a plane defined by the first direction DR1 and the second direction DR2. Images IM generated in the electronic device DD may be provided for a user through the display surface DS.

The display surface DS may include a display area DA and a non-display area NDA around the display area DA. The display area DA may display images IM, and the non-display area NDA may not display an image. The non-display area NDA may be around (*e*.*g*., surround) the display area DA, and may define an edge of the display module DD, which may be printed in a certain color.

The display area DA may have a round cornered rectangular shape according to the shape of the electronic device DD. For example, the display area DA may include sides of a rectangle extending in the first direction DR1 and the second direction DR2, and rounded corners which connect the sides. The sides extending in the first direction DR1 among the four sides may be defined as long sides, and the sides extending in the second direction DR2 among the four sides may be defined as short sides.

The electronic device DD may detect inputs applied from outside of the electronic device DD. For example, the electronic device DD may detect a first input by a touch pen PEN and a second input by a touch TC. The touch pen PEN may be defined as an input device.

The touch pen PEN may be an active pen which outputs a signal. The second input by the touch TC may include one or more suitable types (kinds) of external inputs, such as by part of a user's body, light, heat, or pressure.

The electronic device DD and the touch pen PEN may bidirectionally communicate with each other. The electronic device DD may provide an uplink signal to the touch pen PEN. For example, the uplink signal may include panel information and information on a protocol version and/or the like, but the present disclosure is not particularly limited thereto.

The touch pen PEN may provide a downlink signal to the electronic device DD. The downlink signal may include a synchronization signal or state information of the touch pen PEN. For example, the downlink signal may include coordinate information of the touch pen PEN, battery information of the touch pen PEN, tilting information of the touch pen PEN, and/or various information stored in the touch pen PEN, but the present disclosure is not particularly limited thereto.

The electronic device DD may be used for large-sized electronic devices such as televisions, monitors, or outdoor billboards. The electronic device DD may be used for a small and medium-sized electronic devices such as personal computers, notebook computers, personal digital assistants, vehicle navigation devices, game consoles, smartphones, tablet computers, or cameras. However, these are just provided as examples, and the electronic device DD may be used for other electronic products as long as it does not depart from the scope of the present disclosure.

FIG. 1B illustrates a block diagram of an electronic device DD. Referring to FIG. 1B, the electronic device DD outputs various information through a display module DM in an operating system. When a processor 110 executes an application stored in a memory 120, the display module DM provides application information for a user through a display panel DP.

The processor 110 obtains an external input through an input module 130 or sensor module 161, and executes an application corresponding to the external input. For example, if (*e*.*g*., when) the user selects a camera icon displayed on the display panel DP, the processor 110 obtains a user input through an input sensor 161-2 and activates a camera module 171. The processor 110 transmits, to the display module DM, image data corresponding to a photographic image obtained through the camera module 171. The display module DM may display an image corresponding to the photographic image through the display panel DP.

As another example, if (*e.g.,* when) individual information authentication is performed in the display module DM, a fingerprint sensor 161-1 obtains fingerprint information input as input data. The processor 110 compares the input data obtained through the fingerprint sensor 161-1 with authentication data stored in the memory 120, and executes an application according to a result of the comparison. The display module DM may display, through the display panel DP, information executed according to a logic of the application.

As another example, if (*e.g.,* when) a music streaming icon displayed on the display module DM is selected, the processor 110 obtains a user input through the input sensor 161-2 and activates a music streaming application stored in the memory 120. When a music play command is input to the music streaming application, the processor 110 activates a sound output module 163 and provides the user with sound information corresponding to the music play command.

In the above, the operations of the electronic device DD are briefly described. Hereinafter, components of the electronic device DD will be described in more detail. Among the components of the electronic device DD to be described in more detail later, some components may be integrally provided as one component, and one component may be provided as divided into two or more components.

Referring to FIG. 1B, the electronic device DD may communicate with an external electronic device 102 over a network (*e*.*g*., a short-range wireless communication network or a long-range wireless communication network). The electronic device DD may include the processor 110, the memory 120, the input module 130, the display module DM, a power module 150, a built-in module 160, and an external module 170. In the electronic device DD, at least one of the foregoing components may not be provided, or one or more other components may be added. Some components (*e*.*g*., the sensor module 161, an antenna module 162, or the sound output module 163) of the foregoing components may be integrated into another component (*e*.*g*., the display module DM).

The processor 110 may execute software to control at least one other component (*e*.*g*., a hardware or software component) of the electronic device DD connected to the processor 110, and may perform various data processing and/or computations. As at least a part of the data processing or computation, the processor 110 may store a command or data received from another component (*e*.*g*., the input module 130, the sensor module 161, or a communication module 173) in a volatile memory 121, process the command or data stored in the volatile memory 121, and store the resulting data in a nonvolatile memory 122.

The processor 110 may include a main processor 111 and a coprocessor 112. The main processor 111 may include at least one of a central processing unit (CPU) 111-1 or an application processor (AP). The main processor 111 may also include at least one of a graphic processing unit (GPU) 111-2, a communication processor (CP), or an image signal processor (ISP). The main processor 111 may further include a neural processing unit (NPU) 111-3. The neural processing unit 111-3 may be a processor specialized for processing of an artificial intelligence model, and the artificial intelligence model may be created through machine learning. The artificial intelligence model may include a plurality of artificial neural network layers. The artificial neural network may include one of a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-networks, and/or a (*e.g.,* any suitable) combination of two or more of the foregoing networks, but the present disclosure is not limited to the foregoing examples. Additionally or alternatively, the artificial intelligence model may include a software structure (*e*.*g*., a software structure in addition to a hardware structure). At least two of the foregoing processing units and processors may be implemented as one integrated component (*e*.*g*., a single chip), or the foregoing processing units and processors may be implemented as independent components (*e*.*g*., a plurality of chips).

The coprocessor 112 may include a controller 112-1. The controller 112-1 may include an interface conversion circuit and a timing control circuit. The controller 112-1 receives an image signal from the main processor 111 and outputs image data obtained by converting the data format of the image signal so as to be suitable for the specification of the interface with the display module DM. The controller 112-1 may output one or more suitable control signals for driving the display module DM.

The coprocessor 112 may further include a data conversion circuit 112-2, a gamma correction circuit 112-3, a rendering circuit 112-4, and/or the like. The data conversion circuit 112-2 may receive image data from the controller 112-1, and compensate for the image data such that an image is displayed with a desired or suitable luminance according to the characteristics of the electronic device DD or user settings, or convert the image data to reduce power consumption or compensate for image-sticking. The gamma correction circuit 112-3 may convert image data, a gamma reference voltage, and/or the like, such that an image displayed on the electronic device DD has a desired or suitable gamma characteristic. The rendering circuit 112-4 may receive the image data from the controller 112-1, and render the image data in consideration of a pixel arrangement of the display panel DP applied to the electronic device DD, and/or the like. At least one of the data conversion circuit 112-2, the gamma correction circuit 112-3, or the rendering circuit 112-4 may be integrated into another component (*e*.*g*., the main processor 111 or the controller 112-1). At least one of the data conversion circuit 112-2, the gamma correction circuit 112-3, or the rendering circuit 112-4 may be integrated into a data driver DDV, which will be described in more detail later.

The memory 120 may store various data used by at least one component (*e*.*g*., the processor 110 or the sensor module 161) of the electronic device DD, and input data or output data for relevant commands. The memory 120 may include at least one of the volatile memory 121 or the nonvolatile memory 122.

The input module 130 may receive a command or data to be used in a component (*e*.*g*., the processor 110, the sensor module 161, or the sound output module 163) of the electronic device DD from the outside (*e*.*g*., from the user or from the external electronic device 102) of the electronic device DD..

The input module 130 may include a first input module 131 to which a command or data is input from the user, and a second input module 132 to which a command or data is input from the external electronic device 102. The first input module 131 may include a microphone, a mouse, a keyboard, a key (*e.g.,* a button), or a pen (*e.g.,* a passive pen or an active pen). The second input module 132 may support a designated protocol capable of being connected to the external electronic device 102 in a wired or wireless manner. The second input module 132 may include a high definition multimedia interface (HDMI), a universal serial bus (USB) interface, a secure digital (SD) card interface, or an audio interface. The second input module 132 may include a connector capable of being physically connected to the external electronic device 102, for example, an HDMI connector, a USB connector, an SD card connector, or an audio connector (*e*.*g*., a headphone connector).

The display module DM visually provides information for the user. The display module DM may include the display panel DP, a scan driver SDC and the data driver DDV. The display module DM may further include a window, a chassis, and a bracket for protecting the display panel DP.

The display panel DP may include a liquid crystal display panel, an organic light-emitting display panel, or an inorganic light-emitting display panel, and the type (kind) of the display panel DP is not particularly limited. The display panel DP may be a rigid type (kind), or a flexible type (kind) capable of being rolled or folded. The display module DM may further include a supporter which supports the display panel DP, a bracket, a heat dissipation member, and/or the like.

The scan driver SDC may be mounted as a driving chip on the display panel DP. The scan driver SDC may be integrated into the display panel DP. For example, the scan driver SDC may include an amorphous silicon TFT gate driver circuit (ASG), a low temperature polycrystalline silicon (LTPS) TFT gate driver circuit, or an oxide semiconductor TFT gate driver circuit (OSG), internalized into the display panel DP. The scan driver SDC receives a control signal from the controller 112-1, and outputs scan signals to the display panel DP in response to the control signal.

The display panel DP may further include a light emission driver. The light emission driver outputs an emission control signal to the display panel DP in response to the control signal received from the controller 112-1. The light emission driver may be separated from the scan driver SDC, or may be integrated into the scan driver SDC.

The data driver DDV receives the control signal from the controller 112-1, and converts image data into analog voltages (*e*.*g*., data voltages) in response to the control signal and then outputs the data voltages to the display panel DP.

The data driver DDV may be incorporated into another component (*e*.*g*., the controller 112-1). The functions of the interface conversion circuit and timing control circuit of the controller 112-1 described above may be incorporated into the data driver DDV.

The display module DM may further include the light emission driver, a voltage generation circuit, and/or the like. The voltage generating circuit may output various voltages for driving the display panel DP.

The power module 150 supplies power to the components of the electronic device DD. The power module 150 may include a battery which charges a power voltage. The battery may include a non-rechargeable primary battery, a rechargeable secondary battery, or a fuel battery. The power module 150 may include a power management integrated circuit (PMIC). The PMIC supplies improved or optimized power to each of the modules described above and to the modules to be described in more detail later. The power module 150 may include a wireless power transmission/reception member electrically connected to the battery. The wireless power transmission/reception member may include a plurality of antenna radiators in the form of coils.

The electronic device DD may further include the built-in module 160 and the external module 170. The built-in module 160 may include the sensor module 161, the antenna module 162, and the sound output module 163. The external module 170 may include the camera module 171, a light module 172, and the communication module 173.

The sensor module 161 may detect an input by the user's body or an input by a pen of the first input module 131, and generate an electrical signal or data value corresponding to the input. The sensor module 161 may include at least one of the fingerprint sensor 161-1, the input sensor 161-2, or a digitizer 161-3.

The fingerprint sensor 161-1 may generate a data value corresponding to the user's fingerprint. The fingerprint sensor 161-1 may include one of an optical or capacitance fingerprint sensor.

The input sensor 161-2 may generate a data value corresponding to coordinate information of an input by the user's body or an input by a pen. The input sensor 161-2 generates a capacitance change due to the input as a data value. The input sensor 161-2 may detect an input by the passive pen or transmit/receive data to/from the active pen.

The input sensor 161-2 may measure a bio-signal such as blood pressure, moisture, or body fat. For example, if (*e*.*g*., when) the user touches part of the body to a sensor layer or a sensing panel and does not move for a certain period of time, the input sensor 161-2 may detect a bio-signal and output information related to the bio-signal to the display module DM on the basis of a change in an electric field caused by the part of the body.

The digitizer 161-3 may generate a data value corresponding to coordinate information based on an input by the pen. In response to an input, the digitizer 161-3 generates an electromagnetic change as a data value. The digitizer 161-3 may detect an input by the passive pen or transmit/receive data to/from the active pen.

At least one of the fingerprint sensor 161-1, the input sensor 161-2, or the digitizer 161-3 may be implemented as a sensor layer formed on the display panel DP through a substantially continuous process. The fingerprint sensor 161-1, the input sensor 161-2, and/or the digitizer 161-3 may be arranged above the display panel DP, and any one of the fingerprint sensor 161-1, the input sensor 161-2, and/or the digitizer 161-3, for example, the digitizer 161-3, may be arranged below the display panel DP.

At least two of the fingerprint sensor 161-1, the input sensor 161-2, and/or the digitizer 161-3 may be integrated into one sensing panel through substantially the same process. When the at least two are integrated into the one sensing panel, the sensing panel may be arranged between the display panel DP and a window arranged above the display panel DP. The sensing panel may be arranged on the window, but the position of the sensing panel is not particularly limited.

At least one of the fingerprint sensor 161-1, the input sensor 161-2, or the digitizer 161-3 may be built in the display panel DP. For example, at least one of the fingerprint sensor 161-1, the input sensor 161-2, or the digitizer 161-3 may be concurrently (*e.g.,* simultaneously) formed through a process of forming elements (*e.g.,* light-emitting elements, transistors, and/or the like) included in the display panel DP.

The sensor module 161 may generate an electrical signal or data value corresponding to an internal state or external state of the electronic device DD. The sensor module 161 may further include, for example, a gesture sensor, a gyro sensor, a barometric pressure sensor, a magnetic sensor, an acceleration sensor, a grip sensor, a proximity sensor, a color sensor, an IR (infrared) sensor, a biosensor, a temperature sensor, a humidity sensor, and/or an illuminance sensor.

The antenna module 162 may include one or more antennas for transmitting a signal or power to the outside or receiving a signal or power from the outside. The communication module 173 may be to transmit a signal to an external electronic device or receive a signal from the external electronic device through an antenna suitable for a communication method. An antenna pattern of the antenna module 162 may be integrated into one component (*e*.*g*., the display panel DP) of the display module DM, the input sensor 161-2, and/or the like.

The sound output module 163 may be a device for outputting a sound signal to the outside of the electronic device DD, and may include, for example, a speaker used for general purposes such as multimedia playback or recording playback and a receiver used exclusively for receiving calls. The receiver may be provided integrally with or separately from the speaker. A sound output pattern of the sound output module 163 may be integrated into the display module DM.

The camera module 171 may capture still images and moving images. The camera module 171 may include one or more lenses, image sensors, or image signal processors. The camera module 171 may further include an infrared camera capable of measuring the presence/absence of a user, the user's position, the user's gaze, and/or the like.

The light module 172 may provide light. The light module 172 may include a light-emitting diode or a xenon lamp. The light module 172 may operate in conjunction with the camera module 171 or may operate independently.

The communication module 173 may establish a wired or wireless communication channel between the electronic device DD and the external electronic device 102, and support communication through the established communication channel. The communication module 173 may include one or all of a wireless communication module such as a cellular communication module, a short-range wireless communication module, or a global navigation satellite system (GNSS) communication module, and/or a wired communication module such as a local area network (LAN) communication module or a power line communication module. The communication module 173 may communicate with the external electronic device 102 through a short-range communication network such as Bluetooth, WiFi direct, or infrared data association (IrDA), or a long-range communication network such as a cellular network, the Internet, or a computer network (*e.g.,* LAN or WAN). The foregoing various types (kinds) of communication modules 173 may be implemented as a single chip, or may be implemented as separate chips.

The input module 130, the sensor module 161, the camera module 171, and/or the like may be utilized to control the operation of the display module DM in conjunction with the processor 110.

The processor 110 outputs a command or data to the display module DM, the sound output module 163, the camera module 171, or the light module 172, based on input data received from the input module 130. For example, the processor 110 may generate image data in response to the input data input through a mouse, an active pen, and/or the like, and output the image data to the display module DM, or may generate command data in response to the input data and output the command data to the camera module 171 or the light module 172. When the input data is not received from the input module 130 for a certain period of time, the processor 110 may convert an operation mode of the electronic device DD into a low power mode or a sleep mode, thereby reducing power consumed by the electronic device DD.

The processor 110 outputs a command or data to the display module DM, the sound output module 163, the camera module 171, or the light module 172, based on sensing data received from the sensor module 161. For example, the processor 110 may compare authentication data input by the fingerprint sensor 161-1 with authentication data stored in the memory 120 and then execute an application according to a result of the comparison. The processor 110 may execute a command, based on sensing data detected by the input sensor 161-2 or the digitizer 161-3, and output corresponding image data to the display module DM. When the sensor module 161 includes a temperature sensor, the processor 110 may receive temperature data for temperatures measured from the sensor module 161 and further perform a luminance correction, and/or the like on the image data, based on the temperature data.

The processor 110 may receive measurement data about the presence/absence of a user, the position of the user, the user's gaze, and/or the like from the camera module 171. The processor 110 may further perform the luminance correction and/or the like on the image data, based on the measurement data. For example, the processor 110 having determined the presence/absence of a user through an input from the camera module 171 may output, to the display module DM, image data in which the luminance is corrected through the data conversion circuit 112-2 or the gamma correction circuit 112-3.

Some of the foregoing components may be connected to each other through a communication method between peripheral devices, for example, a bus, a general purpose input/output (GPIO), a serial peripheral interface (SPI), a mobile industry processor interface (MIPI), or an ultra path interconnect (UPI) link, and exchange signals (*e*.*g*., commands or data) with each other. The processor 110 may communicate with the display module DM through an appointed interface. For example, any one of the foregoing communication methods may be used, and the communication method is not limited to the foregoing communication methods.

The electronic devices DD according to one or more embodiments described herein may be one or more suitable types (kinds) of devices. The electronic device DD may include, for example, at least one of a portable communication device (*e*.*g*., a smartphone), a computer device, a portable multimedia device, a portable medical device, a camera, a wearable device, or a home appliance. The electronic device DD according to one or more embodiments herein is not limited to the foregoing devices.

FIG. 2 is a cross-sectional view of the electronic device DD illustrated in FIG. 1A. As an example, FIG. 2 illustrates a cross-section of the electronic device DD when viewed in the second direction DR2. In FIG. 2, some of the components of the electronic device DD, described with reference to FIG. 1B, may not be provided.

Referring to FIG. 2, the electronic device DD may include a display panel DP, an input sensor ISP, an anti-reflective layer RPL, a window WIN, a panel protective film PPF, and first and second adhesive layers AL1 and AL2. The input sensor ISP illustrated in FIG. 2 may be the same component as the input sensor 161-2 described with reference to FIG. 1B.

The display panel DP may be an emissive display panel. For example, the display panel DP may be an organic light-emitting display panel or an inorganic light-emitting display panel. An emission layer of the organic light-emitting display panel may include an organic light-emitting material. An emission layer of the inorganic light-emitting display panel may include a quantum dot, a quantum rod, and/or the like. Hereinafter, the display panel DP is described as the organic light-emitting display panel.

The input sensor ISP may be arranged on the display panel DP. The input sensor ISP may include a plurality of sensing parts for sensing an external input by using a capacitance method. The input sensor ISP may be directly manufactured on the display panel DP during manufacture of the electronic device DD. Thus, the input sensor ISP according to one or more embodiments may be directly arranged on the display panel DP. However, the input sensor ISP is not limited thereto, and may be manufactured as a separate panel from the display panel DP to be attached to the display panel DP through an adhesive layer.

The anti-reflective layer RPL may be arranged on the input sensor ISP. The anti-reflective layer RPL may be directly manufactured on the input sensor ISP during the manufacture of the electronic device DD. However, the anti-reflective layer RPL is not limited thereto, and may be manufactured as a separate panel to be attached to the input sensor ISP through an adhesive layer.

The anti-reflective layer RPL may be defined as a film that prevents the reflection of external light. The anti-reflective layer RPL may reduce the reflectance of external light incident from above the electronic device DD in a direction toward the display panel DP. The external light may not be visible to a user due to the anti-reflective layer RPL.

When external light traveling toward the display panel DP is reflected by the display panel DP and provided for an external user again (*e*.*g*., when external light is reflected back at the user), the external light may be visible to the user like a mirror. To prevent or reduce this phenomenon, the anti-reflective layer RPL may include, for example, a plurality of color filters that display the same colors as pixels of the display panel DP.

The color filters may filter the external light to have the same colors as the pixels. In such embodiments, the external light may not be visible to the user. However, the anti-reflective layer RPL is not limited thereto, and may include a retarder and/or a polarizer in order to reduce the reflectance of the external light.

The window WIN may be arranged on the anti-reflective layer RPL. The window WIN may protect the display panel DP, the input sensor ISP, and the anti-reflective layer RPL from external scratches and/or impacts.

The panel protective film PPF may be arranged below the display panel DP in the third direction DR3. The panel protective film PPF may protect a lower portion of the display panel DP. The panel protective film PPF may include a flexible plastic material such as polyethylene terephthalate (PET).

The first adhesive layer AL1 may be arranged between the display panel DP and the panel protective film PPF, and the display panel DP and the panel protective film PPF may be bonded to each other through the first adhesive layer AL1. The second adhesive layer AL2 may be arranged between the window WIN and the anti-reflective layer RPL, and the window WIN and the anti-reflective layer RPL may be bonded to each other through the second adhesive layer AL2.

FIG. 3 is a cross-sectional view illustrating the display panel illustrated in FIG. 2. As an example, FIG. 3 illustrates a cross-section of a display panel DP when viewed in the second direction DR2.

Referring to FIG. 3, the display panel DP may include a substrate SUB, a circuit element layer DP-CL arranged on the substrate SUB, a display element layer DP-OLED arranged on the circuit element layer DP-CL, and a thin-film encapsulation layer TFE arranged on the display element layer DP-OLED.

The substrate SUB may include a display area DA and a non-display area NDA around the display area DA. The substrate SUB may include glass, or a flexible plastic material such as polyimide. The display element layer DP-OLED may be arranged on the display area DA.

A plurality of pixels may be arranged in the circuit element layer DP-CL and the display element layer DP-OLED. Each of the pixels may include a transistor arranged in the circuit element layer DP-CL, and a light-emitting element arranged in the display element layer DP-OLED and connected to the transistor.

The thin-film encapsulation layer TFE may be arranged on the circuit element layer DP-CL and the display element layer DP-OLED so as to cover the circuit element layer DP-CL and the display element layer DP-OLED. The thin-film encapsulation layer TFE may protect the pixels from moisture, oxygen, and/or external foreign matter. The thin-film encapsulation layer TFE may include inorganic layers and an organic layer. The organic layer may be arranged between the inorganic layers and sealed by the inorganic layers to provide a flat surface. The organic layer may be arranged on the inorganic layers or omitted, and is the present disclosure not limited to any one embodiment.

FIG. 4A is a block diagram of the display module illustrated in FIG. 1A.

Referring to FIG. 4A, the display module DM may include a display panel DP, a timing controller T-C, a scan driver SDC, a data driver DDV, a light emission driver EDV, and a voltage generator VG.

The display panel DP may include a plurality of scan lines GIL1 to GILm, GCL1 to GCLm, GWL1 to GWLm and GBL1 to GBLm, a plurality of emission lines EML1 to EMLm, a plurality of data lines DL1 to DLn, and a plurality of pixels PX. m and n are each a natural number greater than 0.

Pixels PX may be electrically connected to the scan lines GIL1 to GILm, GCL1 to GCLm, GWL1 to GWLm and GBL1 to GBLm, the emission lines EML1 to EMLm, and the data lines DL1 to DLn, respectively. Each of the pixels PX may be electrically connected to four corresponding scan lines, one corresponding data line, and one corresponding emission line.

The scan lines GIL1 to GILm, GCL1 to GCLm, GWL1 to GWLm and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm and GBL1 to GBLm may be connected to the scan driver SDC, and extend in the first direction DR1 to be arranged in the second direction DR2. The emission lines EML1 to EMLm may be connected to the light emission driver EDV, and extend in the first direction DR1 to be arranged in the second direction DR2. The data lines DL1 to DLn may be connected to the data driver DDV, and extend in the second direction DR2 to be arranged in the first direction DR1.

The scan driver SDC, the light emission driver EDV, and the data driver DDV may be substantially arranged on the display module DM and on or around the display panel DP.

The timing controller T-C may receive an image signal RGB and a control signal CTRL. The timing controller T-C may generate an image data signal DAS obtained by converting a data format of the image signal RGB to match an interface specification of the data driver DDV. The timing controller T-C may output a scan control signal SCS, a data control signal DCS, and an emission control signal ECS in response to the control signal CTRL.

The voltage generator VG may generate voltages for an operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDC may receive the scan control signal SCS from the timing controller T-C. The scan driver SDC may output scan signals to the scan lines GIL1 to GILm, GCL1 to GCLm, GWL1 to GWLm and GBL1 to GBLm in response to the scan control signal SCS. The scan signals may be applied to the pixels PX through the scan lines GIL1 to GILm, GCL1 to GCLm, GWL1 to GWLm and GBL1 to GBLm.

The data driver DDV may receive the data control signal DCS and the image data signal DAS from the timing controller T-C. The data driver DDV may convert the image data signal DAS into data signals to output the data signals. The data signals may be defined as analog voltages corresponding to gray levels of the image data signal DAS. The data signals may be applied to the pixels PX through the data lines DL1 to DLn.

The light emission driver EDV may receive the emission control signal ECS from the timing controller T-C. The light emission driver EDV may output emission signals to the emission lines EML1 to EMLm in response to the emission control signal ECS. The emission signals may be applied to the pixels PX through the emission lines EML1 to EMLm.

The pixels PX may receive the data voltages in response to the scan signals. The pixels PX may display an image by emitting light with luminance corresponding to the data voltages in response to the emission signals.

FIG. 4B is a view illustrating an equivalent circuit of one of the pixels illustrated in FIG. 4A. While one pixel PXij is shown in FIG. 4B, the remaining pixels PX may have the same and/or a similar configuration.

As an example, FIG. 4B illustrates a pixel PXij connected to a j-th data line DLj, i-th scan lines GWLi, GCLi, GILi and GBLi, and an i-th emission line EMLi. The letters i and j are each a natural number greater than 0.

Referring to FIG. 4B, the pixel PXij may include a pixel circuit PC and a light-emitting element OLED connected to the pixel circuit PC. The pixel circuit PC may drive the light-emitting element OLED.

The pixel circuit PC may include a plurality of transistors T1 to T8 and a capacitor CST. The transistors T1 to T8 and the capacitor CST may control an amount of current flowing through the light-emitting element OLED. The light-emitting element OLED may generate light having a certain luminance according to an amount of received current.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal GIi, and an i-th bias scan line GBLi may receive an i-th bias scan signal GBi. The i-th emission line EMLi may receive an i-th emission signal EMi.

The pixel PXij may be connected to the j-th data line DLj, the i-th write scan line GWLi, the i-th compensation scan line GCLi, the i-th initialization scan line GILi, the i-th bias scan line GBLi, the i-th emission line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, for the sake of convenience, in FIG. 4B, one of the source electrode and the drain electrode is defined as a first electrode, and the other is defined as a second electrode. The gate electrode is defined as a control electrode.

The transistors T1 to T8 may include first to eighth transistors T1 to T8. The first, second, and fifth to eighth transistors T1, T2 and T5 to T8 may be p-channel metal oxide semiconductor (PMOS) transistors. The third and fourth transistors T3 and T4 may be n-channel metal oxide semiconductor (NMOS) transistors.

The first transistor T1 may be defined as a driving transistor, and the second transistor T2 may be defined as a switching transistor. The third transistor T3 may be defined as a compensation transistor. The fourth transistor T4 and the seventh transistor T7 may each be defined as an initialization transistor. The fifth transistor T5 and the sixth transistor T6 may each be defined as an emission control transistor. The eighth transistor T8 may be defined as a bias transistor.

The light-emitting element OLED may be defined as an organic light-emitting element. The light-emitting element OLED may include a first electrode AE and a second electrode CE. The first electrode AE may be an anode and the second electrode CE may be a cathode, but the present disclosure is not limited thereto. The first electrode AE may receive the first driving voltage ELVDD through the sixth, first, and fifth transistors T6, T1 and T5. The first driving voltage ELVDD may be applied to the pixel circuit PC through the first power line PL1.

The second electrode CE may receive the second driving voltage ELVSS having a lower voltage level than the first driving voltage ELVDD. The second driving voltage ELVSS may be applied to the pixel circuit PC through the second power line PL2.

The first transistor T1 may be arranged between the fifth transistor T5 and the sixth transistor T6 and be connected to the fifth transistor T5 and the sixth transistor T6. The first transistor T1 may be connected to the first power line PL1 through the fifth transistor T5 and be connected to the first electrode AE through the sixth transistor T6.

The first transistor T1 may include a first electrode connected to the first power line PL1 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control an amount of current flowing through the light-emitting element OLED according to a voltage of the first node N1, which is applied to the control electrode of the first transistor T1.

The second transistor T2 may be arranged between the first transistor T1 and the j-th data line DLj, and be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on in response to the i-th write scan signal GWi received through the i-th write scan line GWLi, and electrically connect the j-th data line DLj to the first electrode of the first transistor T1. The second transistor T2 may perform a switching operation of providing a data voltage VD, received through the j-th data line DLj (corresponding to the data signal described above), to the first electrode of the first transistor T1.

The third transistor T3 may be connected to the first node N1 and the second electrode of the first transistor T1. The third transistor T3 may include a first electrode connected to the second electrode of the first transistor T1, a second electrode connected to the first node N1, and a control electrode connected to the i-th compensation scan line GCLi.

The third transistor T3 may be turned on in response to the i-th compensation scan signal GCi received through the i-th compensation scan line GCLi, and electrically connect the second electrode of the first transistor T1 to the control electrode of the first transistor T1. When the third transistor T3 is turned on, the first transistor T1 and the third transistor T3 may be diode-connected.

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on in response to the i-th initialization scan signal GIi received through the i-th initialization scan line GILi, and provide the first initialization voltage VINT, received through the first initialization line VIL1, to the first node N1.

The fifth transistor T5 may include a first electrode connected to the first power line PL1, a second electrode connected to the first electrode of the first transistor T1, and a control electrode connected to the i-th emission line EMLi.

The sixth transistor T6 may include a first electrode connected to the second electrode of the first transistor T1, a second electrode connected to the first electrode AE, and a control electrode connected to the i-th emission line EMLi.

The fifth transistor T5 and the sixth transistor T6 may be turned on in response to the i-th emission signal EMi received through the i-th emission line EMLi. The first driving voltage ELVDD may be provided to the light-emitting element OLED by the turned-on fifth transistor T5 and sixth transistor T6 so that driving current flows to (through) the light-emitting element OLED. Accordingly, the light-emitting element OLED may emit light in response to the current.

The seventh transistor T7 may include a first electrode connected to the first electrode AE, a second electrode connected to the second initialization line VIL2, and a control electrode connected to the i-th bias scan line GBLi. The seventh transistor T7 may be turned on in response to the i-th bias scan signal GBi received through the i-th bias scan line GBLi, and provide the second initialization voltage VAINT, received through the second initialization line VIL2, to the first electrode AE of the light-emitting element OLED.

The second initialization voltage VAINT may have a different voltage level from the first initialization voltage VINT. However, the second initialization voltage VAINT is not limited thereto, and may have the same level as the first initialization voltage VINT.

The seventh transistor T7 may improve black display performance of the pixel PXij. When the seventh transistor T7 is turned on, a parasitic capacitor of the light-emitting element OLED may be discharged. Thus, if (*e*.*g*., when) a black luminance is implemented, the light-emitting element OLED may not emit light due to leakage current from the first transistor T1, and accordingly, the black display performance may be improved.

The capacitor CST may include a first electrode connected to the first power line PL1, and a second electrode connected to the first node N1. When the fifth transistor T5 and the sixth transistor T6 are turned on, an amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on in response to the i-th bias scan signal GBi and provide the bias voltage VBIAS, received through the bias line VBL, to the first electrode of the first transistor T1. However, the transistors included in the pixel PXij are not limited thereto.

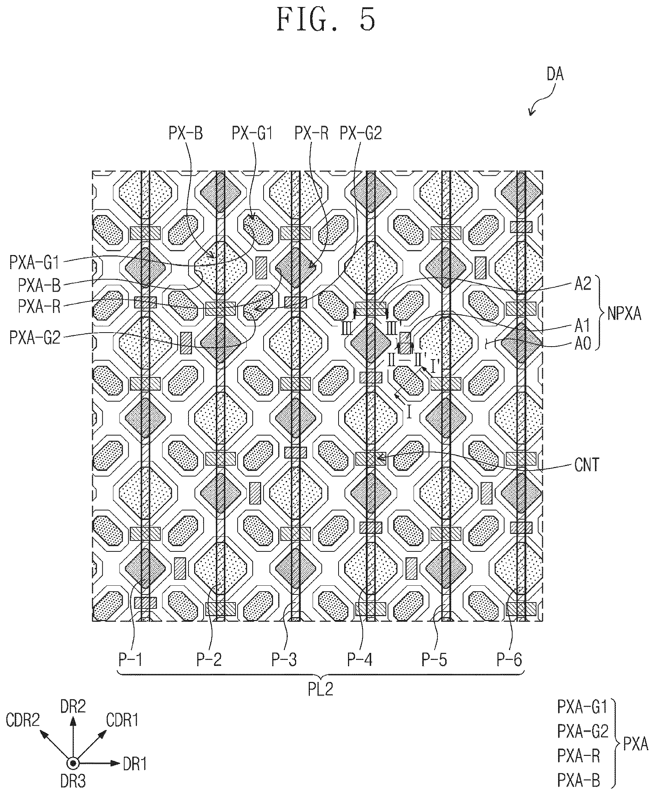

FIG. 5 is a plan view of a portion of the display area DA of the display panel DP.

Referring to FIG. 5, the display area DA of the display panel DP (*see, e.g.,* FIGS. 1B) may include pixel units and each pixel unit may include the pixels described with reference to FIGS. 4A and 4B. The display area DA may include a plurality of pixel units, and the plurality of pixel units may be arranged along first and second diagonal directions CDR1 and CDR2 within the display area DA described with reference to FIG. 1A.

Each pixel unit may include (1-1)-th to third pixels PX-G1, PX-G2, PX-R and PX-B. The (1-1)-th to third pixels PX-G1, PX-G2, PX-R and PX-B may have the same configuration as the pixel PXij described above with reference to FIG. 4B.

The (1-1)-th pixel PX-G1 may provide (emit) green light. The light generated in the (1-1)-th pixel PX-G1 may be provided at (emitted from) the display area DA (*see, e.g.,* FIG. 1A) at (through) a (1-1)-th emission area PXA-G1. The (1-1)-th emission area PXA-G1 may have an octagonal shape extending in the second diagonal direction CDR2 (*e*.*g*., with the major axis extending in the second diagonal direction CDR2).

The (1-2)-th pixel PX-G2 may provide (emit) the same green light as the (1-1)-th pixel PX-G1. The light generated in the (1-2)-th pixel PX-G2 may be provided at (emitted from) the display area DA (*see, e.g.,* FIG. 1A) at (through) a (1-2)-th emission area PXA-G2. The (1-2)-th emission area PXA-G2 may be spaced and/or apart (*e*.*g*., spaced apart or separated) from the (1-1)-th emission area PXA-G1 in the first direction DR1 and the second direction DR2. In such embodiments, the (1-2)-th emission area PXA-G2 may have an octagonal shape extending in the first diagonal direction CDR1 (*e*.*g*., with the major axis extending in the first diagonal direction CDR1).

The second pixel PX-R may provide (emit) red light. The light generated in the second pixel PX-R may be provided at (emitted from) the display area DA (*see, e.g.,* FIG. 1A) at (through) a second emission area PXA-R. The second emission area PXA-R may be spaced and/or apart (*e*.*g*., spaced apart or separated) from a third emission area PXA-B in the first direction DR1 and the second direction DR2. The second emission area PXA-R may be spaced and/or apart (*e*.*g*., spaced apart or separated) from the (1-1)-th emission area PXA-G1 in the second diagonal direction CDR2, and be spaced and/or apart (*e*.*g*., spaced apart or separated) from the (1-2)-th emission area PXA-G2 in the first diagonal direction CDR1. The second emission area PXA-R may be diamond-shaped.

The third pixel PX-B may provide (emit) blue light. The light generated in the third pixel PX-B may be provided at (emitted from) the display area DA (see, *e*.*g*., FIG. 1A) at (through) the third emission area PXA-B. The third emission area PXA-B may be spaced and/or apart (*e*.*g*., spaced apart or separated) from the (1-1)-th emission area PXA-G1 in the first diagonal direction CDR1, and be spaced and/or apart (*e*.*g*., spaced apart or separated) from the (1-2)-th emission area PXA-G2 in the second diagonal direction CDR2. The third emission area PXA-B may be diamond-shaped.

A surface area of the second emission area PXA-R may be greater than a surface area of each of the (1-1)-th and (1-2)-th emission areas PXA-G1 and PXA-G2, and be less than a surface area of the third emission area PXA-B. The emission region PXA may include a 1-1 emission region PXA-G1, a 1-2 emission region PXA-G2, a second emission region PXA-R, and a third emission region PXA-B.

An area between the (1-1)-th to third emission areas PXA-G1, PXA-G2, PXA-R and PXA-B may be defined as a non-emission area NPXA.

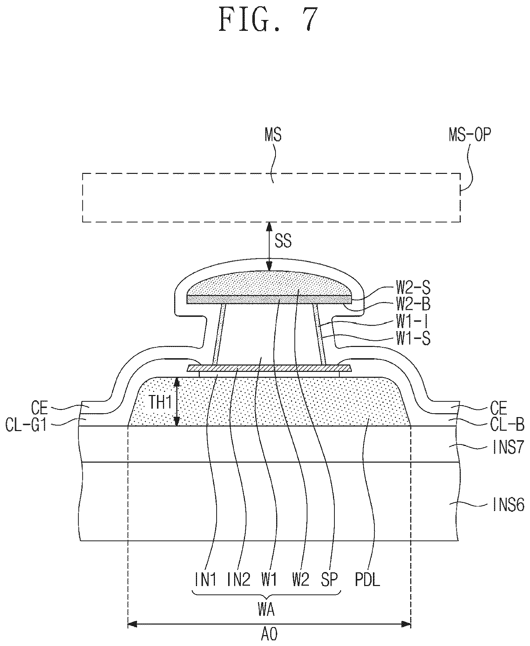

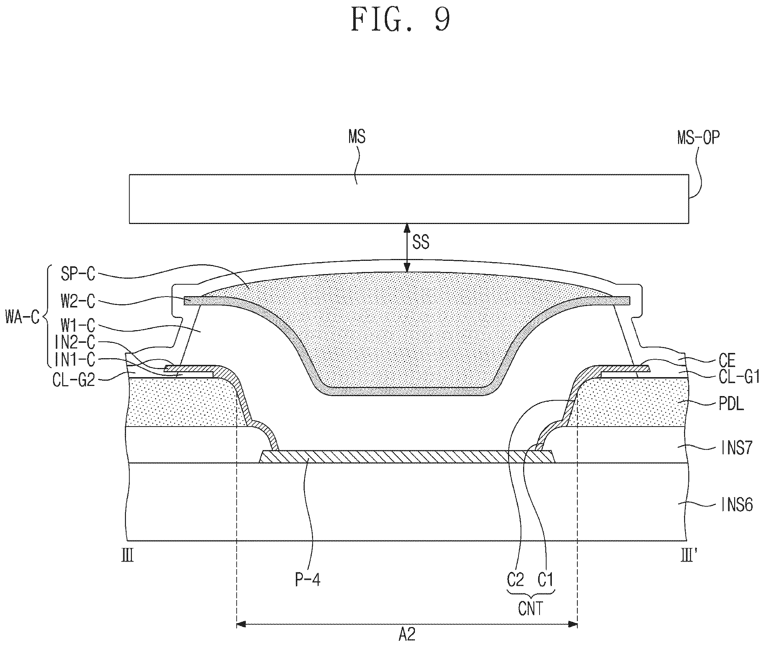

The non-emission area NPXA may include a normal area A0, support areas A1, and contact areas A2. The support areas A1 and the contact areas A2 may be surrounded by the normal area A0 (e.g., within the normal area A0). The support areas A1 and the contact areas A2 may be adjacent to corners of the emission areas PXA-G1, PXA-G2, PXA-R and PXA-B. The support areas A1 and the contact areas A2 may be spaced and/or apart (*e*.*g*., spaced apart or separated) from each other. Partition walls WA and WA-C (*see* FIGS. 7 and 9) may be arranged in the normal area A0, the support areas A1, and the contact areas A2.

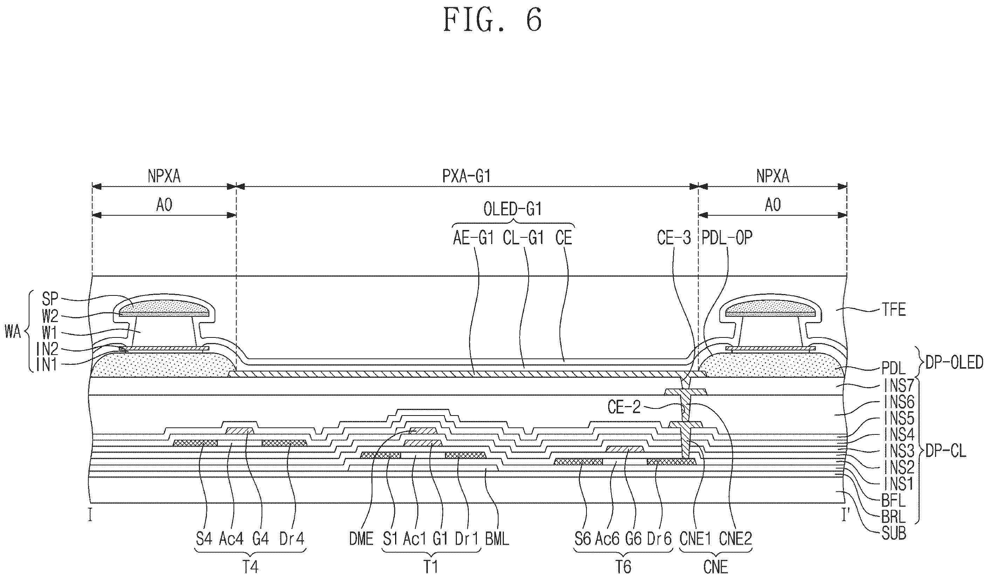

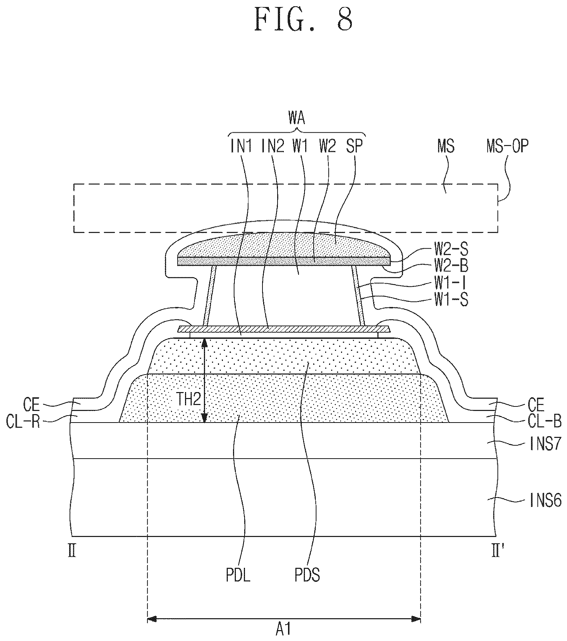

In this specification, the normal area A0 may be defined as an area in which a pixel-defining layer PDL (*see, e.g.,* FIG. 6) is arranged. The partition wall WA (*see, e.g.,* FIG. 8) arranged in the support areas A1 may have a relatively greater height than each of the partition walls WA and WA-C (*see* FIGS. 7 and 9) arranged in the normal area A0 and the contact areas A2. A structure for increasing the height of the partition wall WA may be arranged in the support area A1, and an area in which the structure is arranged may be defined as the support area A1.

The contact areas A2 may be defined as areas at which lines P-1 to P-6 and a contact partition wall WA-C (*see, e.g.,* FIG. 9) are connected through contact holes CNT (*see, e.g.,* FIG. 9) defined in the non-emission area NPXA. The aforementioned lines P-1 to P-6 may be exposed through the contact holes CNT and be in contact with a conductive pattern included in the contact partition wall WA-C. This will be described in more detail later. In FIG. 5, the solid line surrounding each of the emission areas PXA-G1, PXA-G2, PXA-R and PXA-B may correspond to a first electrode of a light-emitting element included in each of the pixels.

The second power line PL2 described with reference to FIG. 4B may be arranged to overlap the display area DA. The second power line PL2 may include the lines P-1 to P-6 which are arranged along the first direction DR1 and each extend in the second direction DR2. Each of the lines P-1 to P-6 may overlap at least one contact area A2 and at least one support area A1. The contact area A2 and the support area A1 overlapped by each of the lines P-1 to P-6 may be different in number.

Each of the lines P-1 to P-6 may be connected to at least one pixel through the contact area A2. This will be described in more detail later.

FIG. 6 is a cross-sectional view taken along the line I-I' in FIG. 5. FIG. 7 is an enlarged cross-sectional view of a partition wall illustrated in FIG. 6.

FIG. 6 illustrates a cross-sectional view of the (1-1)-th pixel PX-G1 illustrated in FIG. 5. Referring to FIG. 6, a light-emitting element OLED-G1 may include a first electrode AE-G1, a second electrode CE, and a (1-1)-th common layer CL-G1. The (1-1)-th common layer CL-G1 may include a hole control layer, an electron control layer, an emission layer, and/or the like. The common layer of the light-emitting element OLED (see, for example, FIG. 4B) may include the (1-1)-th common layer CL-G1, a (1-2)-th common layer CL-G2, a second common layer CL-R, and a third common layer CL-B.

The second electrode CE may be arranged on the first electrode AE-G1, and the (1-1)-th common layer CL-G1 may be arranged between the first electrode AE-G1 and the second electrode CE. The light-emitting element OLED-G1 may further include a protective layer arranged on the second electrode CE. The protective layer may include an organic material and prevent or reduce the likelihood of components, arranged below the protective layer, being damaged in a subsequent process. The protective layer may not be provided.

First, fourth, and sixth transistors T1, T4 and T6 and the light-emitting element OLED-G1 may be arranged on a substrate SUB. The display area DA (*see, e.g.,* FIG. 1A) may include a (1-1)-th emission area PXA-G1 corresponding to the (1-1)-th pixel PX-G1, and a non-emission area NPXA adjacent to the (1-1)-th emission area PXA-G1. FIG. 6 illustrates a partition wall WA arranged in a normal area A0 of the non-emission area NPXA.

The substrate SUB may include glass, or a flexible plastic material such as polyimide. A circuit element layer DP-CL, a display element layer DP-OLED, the partition wall WA, and a thin-film encapsulation layer TFE may be arranged on the substrate SUB. The circuit element layer DP-CL may be arranged on the substrate SUB. The circuit element layer DP-CL may include insulating layers. The display element layer DP-OLED may include the light-emitting element OLED-G1 and a pixel-defining layer PDL.

A barrier layer BRL may be arranged on the substrate SUB. The barrier layer BRL may increase a bonding force between a semiconductor pattern included in transistors and the substrate SUB. The barrier layer BRL may include an inorganic material.

A metal layer BML may be arranged on the barrier layer BRL. The metal layer BML may overlap the first transistor T1. The metal layer BML may receive a constant voltage. When the constant voltage is applied to the metal layer BML, a value of a threshold voltage Vth of the first transistor T1 arranged on the metal layer BML may be maintained without changing.

The metal layer BML may block or reduce light incident on the first transistor T1 from below the metal layer BML. The metal layer BML may include a reflective metal. The metal layer BML may not be provided.

A buffer layer BFL may be arranged on the barrier layer BRL and cover the metal layer BML. The buffer layer BFL may include an inorganic material.

Semiconductor layers S1, Ac1 and Dr1 of the first transistor T1 and semiconductor layers S6, Ac6 and Dr6 of the sixth transistor T6 may be arranged on the buffer layer BFL. The semiconductor layers S1, Ac1, Dr1, S6, Ac6 and Dr6 may include polysilicon. However, the semiconductor layers S1, Ac1, Dr1, S6, Ac6 and Dr6 are not limited thereto, and may include amorphous silicon.

The semiconductor layers S1, Ac1, Dr1, S6, Ac6 and Dr6 may be doped with n-type (kind) dopants or p-type (kind) dopants. The semiconductor layers S1, Ac1, Dr1, S6, Ac6 and Dr6 may include heavy doped regions and light doped regions. The heavy doped regions may have higher conductivity than the light doped regions, and may substantially serve as a source electrode and a drain electrode of each of the first and sixth transistors T1 and T6. The light doped regions may substantially correspond to active regions (channels) of the first and sixth transistors T1 and T6.

A first source region S1, a first channel region Ac1, and a first drain region Dr1 of the first transistor T1 may be provided from the semiconductor layers S1, Ac1 and Dr1. A sixth source region S6, a sixth channel region Ac6, and a sixth drain region Dr6 of the sixth transistor T6 may be provided from the semiconductor layers S6, Ac6 and Dr6. The first channel region Ac1 may be arranged between the first source region S1 and the first drain region Dr1. The sixth channel region Ac6 may be arranged between the sixth source region S6 and the sixth drain region Dr6.

A first insulating layer INS1 may be arranged on the buffer layer BFL so as to cover the semiconductor layers S1, Ac1, Dr1, S6, Ac6 and Dr6. A first gate electrode G1 (or a control electrode) of the first transistor T1 and a sixth gate electrode G6 (or a control electrode) of the sixth transistor T6 may be arranged on the first insulating layer INS1. When viewed on a plane (*e*.*g*., in a plan view), the first gate electrode G1 may overlap the first channel region Ac1, and the sixth gate electrode G6 may overlap the sixth channel region Ac6.

Respective structures of a source region, a channel region, a drain region, and a gate electrode of each of second, fifth, and seventh transistors T2, T5 and T7 may be substantially the same as those of the first and sixth transistors T1 and T6.

A second insulating layer INS2 may be arranged on the first insulating layer INS1 so as to cover the first and sixth gate electrodes G1 and G6. A dummy electrode DME may be arranged on the second insulating layer INS2. The dummy electrode DME may be arranged on the first gate electrode G1, and overlap the first gate electrode G1 when viewed on a plane (*e*.*g*., in a plan view). The dummy electrode DME together with the first gate electrode G1 may constitute the capacitor CST (see, for example, FIG. 4B) described above.

A third insulating layer INS3 may be arranged on the second insulating layer INS2 so as to cover the dummy electrode DME. Semiconductor layers S4, Ac4 and Dr4 of the fourth transistor T4 may be arranged on the third insulating layer INS3. The semiconductor layers S4, Ac4 and Dr4 may include an oxide semiconductor including a metal oxide. The oxide semiconductor may include a crystalline or amorphous oxide semiconductor.

The semiconductor layers S4, Ac4 and Dr4 may include a plurality of regions divided according to whether a metal oxide is reduced. A region in which the metal oxide is reduced (hereinafter referred to as a reduced region) may have a higher conductivity than a region in which the metal oxide is not reduced (hereinafter referred to as a non-reduced region). The reduced region may substantially serve as a source electrode or a drain electrode of the fourth transistor T4. The non-reduced region may substantially correspond to an active region (or channel) of the fourth transistor T4.

A fourth source region S4, a fourth channel region Ac4, and a fourth drain region Dr4 of the fourth transistor T4 may be provided from the semiconductor layers S4, Ac4 and Dr4. The fourth channel region Ac4 may be arranged between the fourth source region S4 and the fourth drain region Dr4.

A fourth insulating layer INS4 may be arranged on the third insulating layer INS3 so as to cover the fourth semiconductor layers S4, Ac4 and Dr4. A fourth gate electrode G4 of the fourth transistor T4 may be arranged on the fourth insulating layer INS4. The fourth gate electrode G4 may overlap the fourth channel region Ac4 when viewed on a plane (*e*.*g*., in a plan view).

A fifth insulating layer INS5 may be arranged on the fourth insulating layer INS4 so as to cover the fourth gate electrode G4. Respective structures of a source region, a channel region, a drain region, and a gate electrode of a third transistor T3 may be substantially the same as those of the fourth transistor T4.

The barrier layer BRL, the buffer layer BFL, and the first to fifth insulating layers INS1 to INS5 may each include an inorganic material. As an example, the barrier layer BRL, the buffer layer BFL, and the first to fifth insulating layers INS1 to INS5 may each include one of silicon oxide and/or silicon nitride, or one insulating layer may include a plurality of inorganic layers and is not limited to any one embodiment. The plurality of inorganic layers may have a structure in which layers including silicon nitride and silicon oxide are alternately stacked.

A connection electrode CNE may be arranged between the sixth transistor T6 and the light-emitting element OLED-G1. The connection electrode CNE may electrically connect the sixth transistor T6 to the light-emitting element OLED-G1. The connection electrode CNE may include a first connection electrode CNE1, and a second connection electrode CNE2 arranged on the first connection electrode CNE1.

The first connection electrode CNE1 may be arranged on the fifth insulating layer INS5, and connected to the sixth drain region Dr6 through a first contact hole defined in the first to fifth insulating layers INS1 to INS5. A sixth insulating layer INS6 may be arranged on the fifth insulating layer INS5 so as to cover the first connection electrode CNE1.

The second connection electrode CNE2 may be arranged on the sixth insulating layer INS6. The second connection electrode CNE2 may be connected to the first connection electrode CNE1 through a second contact hole CE-2 defined in the sixth insulating layer INS6. The first electrode AE may be connected to the second connection electrode CNE2 through a third contact hole CE-3 in a seventh insulating layer INS7.

The second power line PL2 may be arranged on the sixth insulating layer INS6 and covered by the seventh insulating layer INS7 (also referred to as an "interlayer insulating layer").

The seventh insulating layer INS7 may be arranged on the sixth insulating layer INS6 so as to cover the second connection electrode CNE2. The sixth and seventh insulating layers INS6 and INS7 may include one of an inorganic material and/or an organic material.

The lines P-1 to P-6 of the second power line PL2, described with reference to FIG. 5, may be arranged on the sixth insulating layer INS6 and covered by the seventh insulating layer INS7.

The pixel-defining layer PDL may be arranged on the seventh insulating layer INS7. An opening portion PDL-OP which exposes at least a portion of the first electrode AE-G1 may be defined in the pixel-defining layer PDL. The opening portion PDL-OP may correspond to the emission area described above (*e*.*g*., the (1-1)-th emission area PXA-G1). The pixel-defining layer PDL may include an organic material having a light blocking property. The pixel-defining layer PDL may have a certain color. In the display area DA (see, e.g., FIG. 1A), the non-emission area NPXA may be defined as an area in which the pixel-defining layer PDL is arranged, and the emission areas PXA-G1, PXA-G2, PXA-R and PXA-B may each be defined as an area overlapping the opening portion PDL-OP defined in the pixel-defining layer PDL. For example, each emission area PXA-G1, PXA-G2, PXA-R and PXA-B may overlap an opening portion PDL-OP in the pixel-defining layer PDL where the pixel-defining layer PDL has a plurality of opening portions PDL-OP, for example, where the pixel-defining layer PDL has one opening portion PDL-OP corresponding to each pixel PX-G1, PX-G2, PX-R or PX-B.

The light-emitting element OLED-G1 may include the first electrode AE-G1, the (1-1)-th common layer CL-G1, and the second electrode CE. The first electrode AE-G1 may be arranged on the seventh insulating layer INS7 (*e*.*g*., "interlayer insulating layer") and may have a portion exposed by the opening portion PDL-OP.

The (1-1)-th common layer CL-G1 included in the light-emitting element OLED-G1 may be arranged on the first electrode AE-G1. The (1-1)-th common layer CL-G1 may include a hole control layer, an electron control layer, an emission layer, and/or the like.

The second electrode CE may be arranged on the (1-1)-th common layer CL-G1. The second electrode CE may be a single pattern arranged, in common, on the light-emitting elements (*e*.*g*., the second electrode may be a common layer arranged across all the light-emitting elements of the plurality of pixels). The second electrode CE may include a silver-magnesium alloy (AgMg).

As illustrated in FIG. 7, the partition wall WA may be arranged on the pixel-defining layer PDL. For example, the partition wall WA may be entirely arranged on the pixel-defining layer PDL within the non-emission area NPXA.

A height/a shape of the partition wall WA may be different in the normal area A0, the support areas A1, and the contact areas A2 within the non-emission area NPXA. For example, a first distance TH1 from the seventh insulating layer INS7 (*e*.*g*., the "interlayer insulating layer") to the partition wall WA arranged in the normal area A0 may be less than a second distance TH2 *(see, e.g.,* FIG. 8) from the seventh insulating layer INS7 (*e*.*g*., the "interlayer insulating layer") to the partition wall WA arranged in the support areas A1.

The contact partition wall WA-C arranged in each of the contact areas A2 may be arranged in a contact hole CNT (*see, e.g.,* FIG. 9) overlapping the contact area A2, and thus have a different shape from the partition walls WA arranged in the normal area A0 and the support areas A1.

The partition wall WA may include a first insulating pattern IN1, a second insulating pattern IN2, a first partition wall pattern W1, a second partition wall pattern W2, and a spacer SP.

The first insulating pattern IN1 may be directly arranged on the pixel-defining layer PDL. The first insulating pattern IN1 may include an inorganic material. The second insulating pattern IN2 may be arranged on the first insulating pattern IN1. The second insulating pattern IN2 may include a different inorganic material from the first insulating pattern IN1.

For example, the first insulating pattern IN1 may include at least one of indium zinc oxide, indium gallium zinc oxide, or indium tin oxide, and the second insulating pattern IN2 may include at least one of silicon oxide, silicon oxynitride, or silicon nitride.

The first insulating pattern IN1 may be a component for disconnecting a p-type (kind) hole injection layer among layers included in a (1-1)-th common layer CL-G1. Thus, a thickness of the first insulating pattern IN1 may be greater than a thickness of the p-type (kind) hole injection layer among the layers included in the (1-1)-th common layer CL-G1.

In a cross-sectional view, a width (*e*.*g*., in a first and/or second direction DR1 and/or DR2) of the second insulating pattern IN2 may be greater than a width of the first insulating pattern IN1. A difference in width as above may occur due to a difference in etch rate for an etchant between the first insulating pattern IN1 and the second insulating pattern IN2.

A stepped portion may be generated between a portion of the second insulating pattern IN2 overlapping the first partition wall pattern W1 and the remaining portion of the second insulating pattern IN2 not overlapping the first partition wall pattern W1. The thickness (*e*.*g*., in the third direction DR3) of the portion of the second insulating pattern IN2 overlapping the first partition wall pattern W1 may be greater than the thickness of the remaining portion of the second insulating pattern IN2 that is exposed from (*e*.*g*., not overlapping) the first partition wall pattern W1.

Common layers included in different pixels may be disconnected from each other by the first insulating pattern IN1 and the second insulating pattern IN2 at the partition wall WA arranged between the common layers, and the disconnected common layers may each be in contact with a side surface of the first insulating pattern IN1 and a side surface and a top surface of the second insulating pattern IN2. For example, during the manufacturing of the common layer, the height of the partition wall WA may cause the common layer to be disconnected in the non-emission area NPXA, leading to a separate common layer for each of the pixels.

The first partition wall pattern W1 is arranged on the second insulating pattern IN2. The first partition wall pattern W1 may include a metal. For example, the first partition wall pattern W1 may include aluminum. As the first partition wall pattern W1 includes aluminum, a side surface W1-S of the first partition wall pattern W1 may be oxidized to have no conductivity. Thus, an inner side W1-I of the side surface W1-S of the first partition wall pattern W1 may be a nonconductor (*e*.*g*., nonconductive) area.

The second partition wall pattern W2 may be arranged on the first partition wall pattern W1. The second partition wall pattern W2 may include a different metal from the first partition wall pattern W1. For example, the second partition wall pattern W2 may include titanium.

A thickness of the first partition wall pattern W1 may be greater than a thickness of the second partition wall pattern W2, and a width of the first partition wall pattern W1 may be less than a width of the second partition wall pattern W2. A portion of the second partition wall pattern W2 may protrude from the first partition wall pattern W1 to be exposed from the first partition wall pattern W1. Thus, a bottom surface W2-B of the second partition wall pattern W2 may be exposed from the first partition wall pattern W1. This may occur due to a difference in etch rate for an etchant between the first partition wall pattern W1 and the second partition wall pattern W2. The first partition wall pattern W1 and the second partition wall pattern W2 may be defined as having a tip (or overhang) structure.

The spacer SP may be arranged on the second partition wall pattern W2. The spacer SP may include a transparent organic material. When a mask MS (illustrated with dotted lines) which is used for a process of depositing components included in the common layers and includes a deposition opening portion MS-OP is arranged, the spacer SP may be to absorb impact to safely support the components arranged below the spacer SP.

The partition wall WA arranged in the normal area A0 may be spaced a certain space (distance) SS from the mask MS. Thus, the mask MS may be spaced from the spacer SP in the normal area A0, and accordingly, damage may not occur in the process of using the mask MS so that the tip structure of the partition wall WA arranged in the normal area A0 is stably maintained. The mask MS may be a fine metal mask used for a process of forming the (1-1)-th common layer CL-G1 (*see, e.g.,* FIG. 6), before the forming of the second electrode CE.

The second electrode CE may extend from the emission areas PXA-G1, PXA-G2, PXA-R and PXA-B to the non-emission area NPXA and cover the partition wall WA. The second electrode CE overlapping the partition wall WA may be in contact with the side surface W1-S of the first partition wall pattern W1, the bottom surface W2-B of the second partition wall pattern W2 exposed from the first partition wall pattern W1, a side surface W2-S of the second partition wall pattern W2, and the spacer SP.

As described above, the inner side W1-I of the first partition wall pattern W1 may include the nonconductor area oxidized to have no conductivity, and thus the second electrode CE which covers the partition wall WA may be connected to the other portion of the second electrode CE through the bottom surface W2-B of the second partition wall pattern W2, exposed from the first partition wall pattern W1, and the side surface W2-S of the second partition wall pattern W2.

A first thickness of the second electrode CE arranged on the (1-1)-th common layer CL-G1 may be greater than a second thickness of the second electrode CE which covers the partition wall WA. The second electrode CE may be in contact with only one portion of the side surface W1-S of the first partition wall pattern W1 and be disconnected on the side surface W1-S of the first partition wall pattern W1. The remaining portion of the second electrode CE may be in contact with the side surface W2-S of the second partition wall pattern W2 and the spacer SP. The second electrodes CE disconnected on the partition wall WA may be in contact with the partition wall WA including a conductive material (*e*.*g*., the first or second partition wall pattern W1 or W2), and thus be electrically connected by the partition wall WA.

The thin-film encapsulation layer TFE may be arranged on the light-emitting element OLED-G1 to cover the light-emitting element OLED-G1. The thin-film encapsulation layer TFE may be arranged over the entirety of the display area DA. The thin-film encapsulation layer TFE may include inorganic layers and an organic layer arranged between the inorganic layers, and is not limited to any one embodiment. In the organic layer included in the thin-film encapsulation layer TFE, a boundary may be defined in the non-display area NDA (*see, e.g.,* FIG. 2) by a dam pattern arranged in the non-display area NDA (*see, e.g.,* FIG. 2).

FIG. 8 is a cross-sectional view taken along the line II-II' in FIG. 5. FIG. 9 is a cross-sectional view taken along the line III-III' in FIG. 5. Partition walls WA and WA-C to be described with reference to FIGS. 8 and 9 may be similar to and may extend from the partition wall WA in the normal area A0, and differences in height and shape of the partition wall WA between areas will be mainly described.

Referring to FIG. 8, stepped organic patterns PDS may be arranged in support areas A1 of the non-emission area NPXA (*see, e.g.,* FIG. 5). The stepped organic patterns PDS may be arranged between the pixel-defining layer PDL and the partition wall WA. FIG. 5 illustrates patterns each having a relatively small rectangular shape at a point at which corners of the emission areas PXA-G1, PXA-G2, PXA-R and PXA-B intersect or are adjacent to each other, and the patterns each having the rectangular shape and not overlapping the second power line PL2 may correspond to the areas in which the stepped organic patterns PDS are arranged.

Thus, the stepped organic patterns PDS may be arranged at the point at which the emission areas PXA-G1, PXA-G2, PXA-R and PXA-B intersect or are adjacent to each other. The stepped organic patterns PDS may be spaced and/or apart (*e*.*g*., spaced apart or separated) from contact holes CNT *(see, e.g.,* FIG. 9) defined in contact areas A2.

A surface area of the stepped organic patterns PDS within the display area DA (*see, e.g.,* FIGS. 1A and 5) may be in a range of 1% to 10% of an entire surface area of the display area DA (*see, e.g.,* FIGS. 1A and 5).

The partition wall WA may be arranged on the stepped organic patterns PDS in an area overlapping support areas A1. Thus, a bottom surface of each of the stepped organic patterns PDS may be in contact with the pixel-defining layer PDL, and a top surface of each of the stepped organic patterns PDS may be in contact with the partition wall WA.

The stepped organic patterns PDS may include the same material as the spacer SP. For example, the stepped organic patterns PDS may each include a transparent organic material.

The organic layer included in the thin-film encapsulation layer TFE described with reference to FIG. 6 may be arranged on an entire surface of the display area DA (*see, e*.*g*., FIG. 1A), and a boundary may be defined by a dam pattern in the non-display area NDA (*see, e.g.,* FIG. 1A).

At least one dam pattern arranged in the non-display area NDA (*see, e.g.,* FIG. 1A) may include a plurality of organic layers. The plurality of organic layers included in the at least one dam pattern may include the same material as one of a seventh insulating layer INS7, the pixel-defining layer PDL, the stepped organic patterns PDS, and/or the spacer SP.

The partition wall WA may have the shape of one body in the normal area A0 and the support areas A1 (*e.g.,* the partition wall WA may be a singular body across both in the normal area A0 and the support areas A1). Thus, in the normal area A0, the partition wall WA may have a first distance TH1 from the seventh insulating layer INS7 and be arranged on the pixel-defining layer PDL, and only in the support areas A1 will the partition wall WA have a second distance TH2 greater than the first distance TH1 from the seventh insulating layer INS7 and be arranged on the stepped organic patterns PDS.

The partition wall WA arranged in the support areas A1 may be in contact with a mask MS. During the process of forming the (1-1)-th common layer CL-G1 (*see, e.g.,* FIG. 6), before the second electrode CE is formed, the mask MS may be in contact with the spacer SP of the partition wall WA.

For example, if (*e*.*g*., when) performing the process of forming the (1-1)-th common layer CL-G1 (*see, e.g.,* FIG. 6), the mask MS may be spaced and/or apart (*e.g.,* spaced apart or separated) from the partition wall WA in the normal area A0, and the mask MS may be in contact with the spacer SP of the partition wall WA in the support areas A1. For example, the mask MS may be in contact with the taller partition wall WA in the support areas A1 (taller due to the stepped organic patterns PDS), thus preventing or reducing the likelihood of the mask MS being in contact with the partition wall WA in the normal area A0. Thus, when using the mask MS, the mask MS and the partition wall WA may be spaced from each other in the normal area A0, to reduce or avoid damage to the tip (overhang structure) and to thereby more stably maintain the tip structure of the partition wall WA in the normal area A0.

Referring to FIG. 9, contact holes CNT which expose a second power line PL2 may be defined in contact areas A2. FIG. 9 illustrates an example in which a portion of a fourth line P-4 of the lines P-1 to P-6 (*see, e.g.,* FIG. 5) crossing the display area DA (*see, e*.*g*., FIG. 5) is exposed by the contact holes CNT.

The contact holes CNT may include a first hole C1 passing through a seventh insulating layer INS7, and a second hole C2 overlapping the first hole C1 and passing through a pixel-defining layer PDL. A width of the second hole C2 may be greater than a width of the first hole C1.

The partition wall WA may be arranged inside the contact holes CNT in the contact areas A2, and thus a shape of the partition wall WA in the contact areas A2 may be different from the shape of the partition wall WA in the normal area A0 and the support areas A1. For convenience of explanation, the partition wall WA overlapping the contact areas A2 will be described as a contact partition wall WA-C.

An opening portion overlapping the contact holes CNT may be defined in a first insulating pattern IN1-C of the contact partition wall WA-C. The first insulating pattern IN1-C may not overlap the contact holes CNT but be arranged on the pixel-defining layer PDL.

A second insulating pattern IN2-C may cover the first insulating pattern IN1-C on the pixel-defining layer PDL, and cover a side surface of the seventh insulating layer INS7, which defines the first hole C1, and a side surface of the pixel-defining layer PDL which defines the second hole C2. The second insulating pattern IN2-C together with the first hole C1 and the second hole C2 may expose the fourth line P-4.

A first partition wall pattern W1-C may be arranged on the second insulating pattern IN2-C and the fourth line P-4, and be in contact with the fourth line P-4. A second partition wall pattern W2-C may be arranged on the first partition wall pattern W1-C, and a spacer SP-C may be arranged on the second partition wall pattern W2-C.

In a process using a mask MS, the contact partition wall WA-C may be spaced a certain space (distance) SS from the mask MS. Thus, the contact partition wall WA-C may not be damaged in the process of using the mask MS. Thus, a contact structure of the contact partition wall WA-C and the second power line PL2 may be stably maintained.

The second electrode CE may be connected to the second power line PL2 through the partition wall WA within the display area DA (*see, e.g.,* FIG. 1A), thereby preventing or reducing the likelihood of a voltage drop and allowing a constant voltage to be provided to pixels. As the connection between the second electrode CE and the second power line PL2 is achieved within the display area DA (*see, e.g.,* FIG. 1A), an unnecessary space for connecting the second electrode CE to the second power line PL2 may be reduced in the non-display area NDA. For example, additional space does not need to be dedicated to providing a connection between the second electrode CE and the second power line PL2 in the non-display area NDA, reducing the size of the non-display area NDA. Moreover, pixel units having different resolutions may be individually driven.

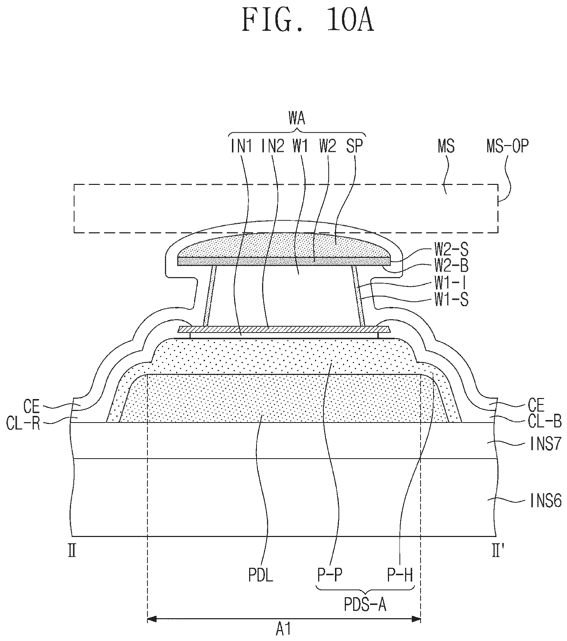

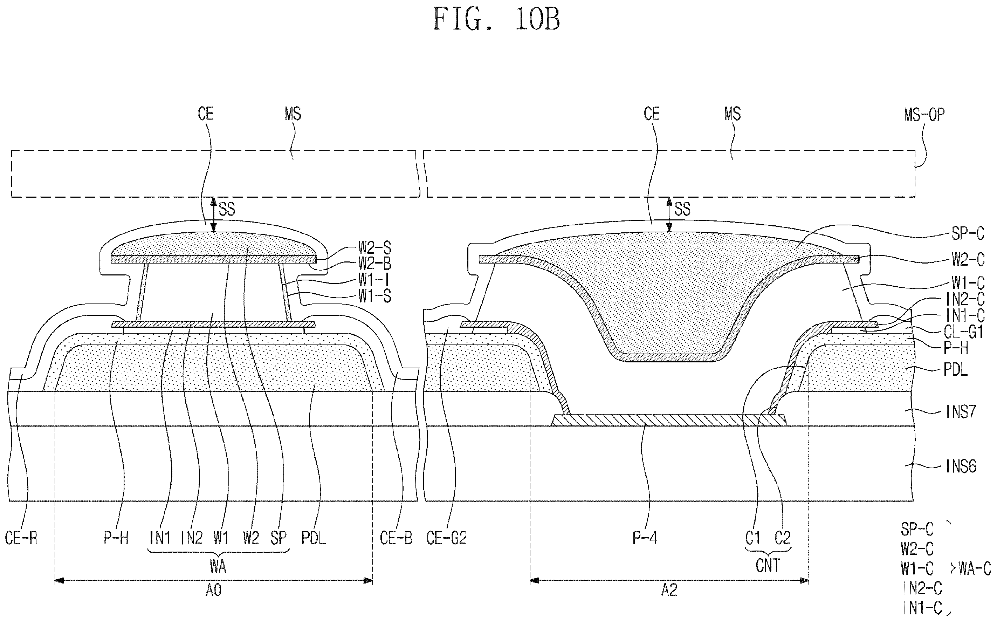

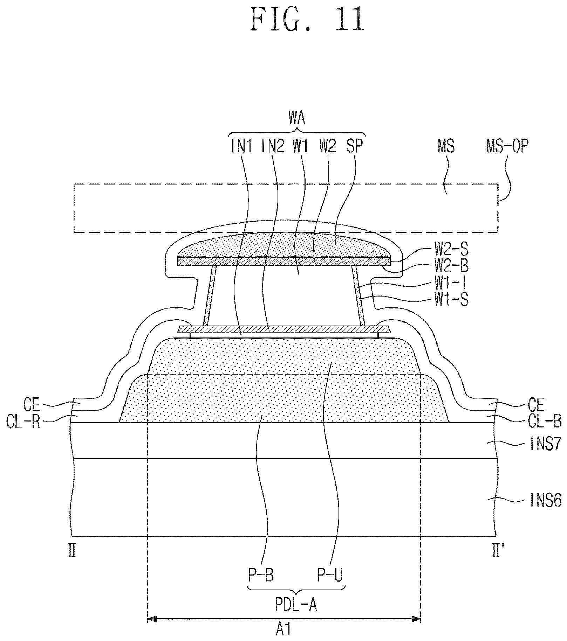

In another example, FIG. 10A is a cross-sectional view taken along the line II-II' in FIG. 5 of a partition wall arranged in a support area A1. FIG. 10B is a cross-sectional view of a partition wall arranged in a normal area and a contact area. FIG. 11 is a cross-sectional view taken along the line II-II' in FIG. 5 of a partition wall arranged in a support area. The same and/or similar components as/to those described with reference to FIGS. 1A to 9 are designated by the same and/or similar reference symbols, and the redundant descriptions thereof may not be provided.

Referring to FIGS. 10A and 10B, the display panel DP (*see, e.g.,* FIG. 2) may include a stepped organic film PDS-A. The stepped organic film PDS-A may include a first pattern P-H and second patterns P-P. The stepped organic film PDS-A may include a transparent organic material. The first pattern P-H may have a smaller thickness than the second patterns P-P. A difference in thickness between the first pattern P-H and the second patterns P-P may occur due to a half-tone exposure process.

The first pattern P-H may cover the pixel-defining layer PDL overlapping a normal area A0 and contact areas A2. The first pattern P-H may cover a side surface of the pixel-defining layer PDL which defines the second hole C2 of the contact holes CNT, and expose a side surface of the seventh insulating layer INS7 which defines the first hole C1 of the contact holes CNT. In the normal area A0 and the contact areas A2, the partition wall WA and the contact partition wall WA-C may be arranged on the first pattern P-H.

The second patterns P-P may be arranged in support areas A1 and between the partition wall WA and the pixel-defining layer PDL. The second patterns P-P are components integrated with the first pattern P-H, but will be described separately for convenience of explanation. The second patterns P-P may perform the same function as the stepped organic patterns PDS described with reference to FIG. 8. For example, the second patterns P-P may be structures for allowing the partition wall WA arranged in the support areas A1 to have a greater height than the partition wall WA and the contact partition wall WA-C arranged in the normal area A0 and the contact area A2.

Referring to FIG. 11, a pixel-defining layer PDL-A may include a lower layer P-B and an upper layer P-U. The lower layer P-B may correspond to the pixel-defining layer PDL described with reference to FIGS. 6 and 7, and the upper layer P-U may correspond to the stepped organic patterns PDS described with reference to FIG. 8. Thus, the upper layer P-U may perform the same function as the stepped organic patterns PDS.

The upper layer P-U may include the same material as the lower layer P-B. For example, the upper layer P-U and the lower layer P-B may include an organic material having a light blocking property.

The second electrode may be connected to the power line through the partition wall within the display area, and thus a voltage drop may be prevented or the likelihood of a voltage drop may be reduced, allowing a constant voltage to be provided to the pixels. In addition, as the connection between the second electrode and the power line is achieved within the display area, it is unnecessary to dedicate a space for connecting the second electrode to the second power line in the non-display area, and thus the area of the non-display area may be reduced.

Moreover, the partition wall which supports the mask and the partition wall which connects the second electrode may be distinguished between the areas to stably maintain the tip structure of the partition wall. For example, partition walls connecting the second electrode to the power line may be different from partition walls that support the mask used during deposition of various light-emitting layers (*e*.*g*., the common layers), thus protecting the partition walls connecting the second electrode to the power line from damage due to the mask and allowing the structure (*e*.*g*., the tip or overhang structure) of the partition walls connecting the second electrode to the power line to be maintained.

Further, the use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "substantially" may mean within one or more standard deviations, or within ± 30%, 20%, 10%, 5% of the stated value.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The display device, electronic device, device for manufacturing the display device, and/or any other relevant devices or components according to embodiments of the present disclosure described herein may be implemented utilizing any suitable hardware, firmware (*e*.*g*., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. It is to be understood that the foregoing is an illustration of various example embodiments and is not to be construed as limited to the specific embodiments disclosed herein, and that various modifications to the disclosed embodiments, as well as other example embodiments, are intended to be included within the spirit and scope of the present disclosure as defined in the appended claims, and their equivalents.

### Description of the Symbols

| | | | |
|---|---|---|---|
| DD: | Electronic device | DP: | Display panel |
| DA: | Display area | NDA: | Non-display area |
| PXA--R, PXA-G, PXA-B: | Emission area | NPXA: | Non-emission area |
| WA: | Partition wall | INS7: | Seventh insulating layer/interlayer insulalayer |
| PDL: | Pixel-defining layer | PDS: | Stepped organic patterns |

## Claims

1. An electronic device comprising:
a substrate (SUB) comprising a display area (DA) comprising
emission areas (PXA-R, PXA-B, PXA-G), and
a non-emission area (NPXA) between the emission areas and comprising a normal area (A0) and support areas (A1);
an interlayer insulating layer (INS7) on the substrate;
a pixel-defining layer (PDL) on the interlayer insulating layer and defining opening portions overlapping the emission areas;
light emitting elements (OLED), each comprising
a first electrode (AE) on the interlayer insulating layer and overlapping a respective one of the opening portions,
a common layer (CL) on the first electrode, and
a second electrode (CE) on the common layer; and
a partition wall (WA) on the pixel-defining layer and overlapping the non-emission area (NPXA),
wherein the distance (TH2) from the interlayer insulating layer (INS7) to the partition wall (WA) in each of the support areas (A1) is greater than the distance (TH1) from the interlayer insulating layer (INS7) to the partition wall (WA) in the normal area (A0).

2. The electronic device of claim 1, further comprising stepped organic patterns (PDS) between the partition wall (WA) and the pixel-defining layer (PDL), the stepped organic patterns overlapping the support areas.

3. The electronic device of claim 2, wherein the pixel-defining layer comprises an organic material having a light blocking property and the pixel-defining layer has a certain color.

4. The electronic device of claim 2 or 3, wherein the stepped organic patterns each comprise a transparent organic material, and/or wherein the stepped organic patterns comprise the same material as the pixel-defining layer.

5. The electronic device of any one of claims 2 to 4, wherein a surface area of the stepped organic patterns within the display area is in a range of 1% to 10% of a surface area of the display area.

6. The electronic device of claim 1, further comprising a stepped organic film (PDS-A) comprising a first pattern (P-H) covering the pixel-defining layer, and second patterns (P-P) connected to the first pattern and between the partition wall (WA) and the pixel-defining layer (PDL), each of the second patterns overlapping a respective one of the support areas (A1),
wherein the thickness of each of the second patterns (P-P) is greater than the thickness of the first pattern (P-H).

7. The electronic device of any one of the preceding claims, wherein the partition wall (WA) comprises a first insulating pattern (IN1), a second insulating pattern (IN2) on the first insulating pattern, a first partition wall pattern (W1) on the second insulating pattern, a second partition wall pattern (W2) on the first partition wall pattern, and a spacer (SP) on the second partition wall pattern.

8. The electronic device of claim 7, wherein the first insulating pattern comprises at least one of indium zinc oxide, indium gallium zinc oxide, or indium tin oxide, and
the second insulating pattern comprises at least one of silicon oxide, silicon oxynitride, or silicon nitride, and/or wherein the first partition wall pattern comprises aluminum, and
the second partition wall pattern comprises titanium, and/or
wherein the spacer comprises a transparent organic material.

9. The electronic device of claim 7 or 8, wherein the thickness of the first partition wall pattern is greater than the thickness of the second partition wall pattern,
the width of the second partition wall pattern is greater than the width of the first partition wall pattern, and
a portion of a bottom surface of the second partition wall pattern protrudes from the first partition wall pattern and is exposed from the first partition wall pattern.

10. The electronic device of claim 9, wherein the second electrode is a single pattern provided in common to the light emitting elements, and
the second electrode extends from the emission areas to the non-emission area and covers a side surface of the first partition wall pattern, the portion of the bottom surface of the second partition wall pattern, and the spacer, the electronic device further comprising power lines configured to provide power to the light emitting elements, overlapping the display area, and between the interlayer insulating layer and the substrate.

11. The electronic device of claim 10, wherein the non-emission area further comprises contact areas (A2) within the normal area and spaced from the support areas,
wherein, in the contact areas, the interlayer insulating layer and the pixel-defining layer define contact holes (CNT) passing through the interlayer insulating layer and the pixel-defining layer, respectively, and the contact holes expose the power lines, and
wherein the first partition wall pattern (W1-C) is in contact with the power lines exposed by the contact holes.

12. The electronic device of claim 11, wherein, in the contact areas, the first insulating pattern is on the pixel-defining layer, and the second insulating pattern covers a side surface of the pixel-defining layer and a side surface of the interlayer insulating layer which define the contact holes.

13. The electronic device of any one of claims 7 to 12, further comprising an encapsulation layer on the pixel-defining layer and covering the light emitting elements,
wherein the encapsulation layer comprises inorganic layers and an organic layer between the inorganic layers, wherein the substrate comprises a non-display area around at least a portion of the display area,
and the electronic device further comprises a dam pattern on the substrate and defining a boundary of the organic layer in the non-display area.

14. The electronic device of claim 13, wherein the dam pattern comprises a plurality of layers,
wherein the layers comprise the same material as at least one of the interlayer insulating layer, the pixel-defining layer, the stepped organic patterns, or the spacer.

15. The electronic device of any one of the preceding claims, wherein the emission areas comprise a first emission area to emit light of a first color, a second emission area to emit light of a second color different from the first color and spaced from the first emission area in a first direction, and a (3-1)-th emission area and a (3-2)-th emission area, each of which are to emit light of a third color different from the first and second colors and which are spaced from each other in a second direction crossing the first direction,
wherein the (3-1)-th emission area is spaced from the first emission area in a first diagonal direction crossing the first and second directions, and
the (3-2)-th emission area is spaced from the second emission area in a second diagonal direction crossing the first diagonal direction.
